(19) Europäisches Patentamt
European Patent Office
Office européen des brevets

(11) **EP 2 421 146 B1**

(12) **EUROPÄISCHE PATENTSCHRIFT**

(45) Veröffentlichungstag und Bekanntmachung des Hinweises auf die Patenterteilung:
**11.02.2015 Patentblatt 2015/07**

(51) Int Cl.:
*H02P 21/14* (2006.01)    *H02P 23/14* (2006.01)
*G01R 31/34* (2006.01)

(21) Anmeldenummer: **10172908.5**

(22) Anmeldetag: **16.08.2010**

(54) **Vorrichtung und Verfahren zur drehgeberlosen Identifikation magnetomechanischer Kenngrößen eines Drehstrom-Synchronmotors**

Device and method for identifying magnetomechanical parameters of an alternating current synchronous motor without using a rotary encoder

Dispositif et procédé d'identification des paramètres de référence magnéto-mécaniques d'un moteur synchrone triphasé sans utilisation d'encodeur de vitesse

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(43) Veröffentlichungstag der Anmeldung:
**22.02.2012 Patentblatt 2012/08**

(73) Patentinhaber: **Baumüller Nürnberg GmbH 90482 Nürnberg (DE)**

(72) Erfinder:
• **Sebastian, Villwock**
  **95701 Pechbrunn (DE)**
• **Zatocil, Heiko**
  **90429, Nürnberg (DE)**

(74) Vertreter: **Götz, Georg Alois
Intellectual Property IP-GÖTZ
Patent- und Rechtsanwälte
Postfach 35 45
90017 Nürnberg (DE)**

(56) Entgegenhaltungen:
**EP-A2- 1 758 239    JP-A- 2010 041 839**

• **VILLWOCK S ET AL: "Influence of the power density spectrum of the excitation signal on the identification of drives", INDUSTRIAL ELECTRONICS, 2008. IECON 2008. 34TH ANNUAL CONFERENCE OF IEEE, IEEE, PISCATAWAY, NJ, USA, 10. November 2008 (2008-11-10), Seiten 1252-1257, XP031410622, ISBN: 978-1-4244-1767-4**
• **KHALIL H S ET AL: "Identification of synchronous machine models using power spectral analysis", CONTROL 1991. CONTROL '91., INTERNATIONAL CONFERENCE ON EDINBURGH, UK, LONDON, UK,IEE, UK, 1. Januar 1991 (1991-01-01), Seiten 92-97, XP006516298, ISBN: 978-0-85296-509-2**

**Beschreibung**

Die vorliegende Erfindung geht aus von einem Verfahren, einer Einrichtung, einer Vorrichtung und einer Verfahrensverwendung für eine drehgeberlose Identifikation magnetomechanischer Kenngrößen, insbesondere Massenträgheitsmoment $J$ des Rotors und Permanentmagnetfluss $\Psi_{PM}$ zwischen Rotor und Stator eines Drehstrom-Synchronmotors. Magnetomechanischer Kenngrößen ermöglichen die Charakterisierung eines Drehstrommotors in Bezug auf die magnetische Interaktion zwischen Stator und Rotor und mechanische Dynamikverhalten, so dass sowohl das magnetische als auch das mechanisch-rotatorische Verhalten des Motors im Betrieb charakterisiert werden kann.

STAND DER TECHNIK

Aus dem Stand der Technik, z.B. der EP 1 758 239 A2, der JP 2010 041839 A oder aus "Villwock, S. et al, "Influence of the power density spectrum of the excitation signal, on the identification of drives", INDUSTRIAL ELECTRONICS, 2008. IECON 2008. 34TH ANNUAL CONFERENCE OF IEEE, IEEE, PISCATAWAY, NJ, USA, 10. November 2008 (2008-11-10), Seiten 1252-1257, XP0314106221SBN: 978-1-4244-1767-4", sind verschiedene Methoden bekannt, um das magnetische und das mechanische Verhalten eines Drehstrommotors zu bestimmen. In der Regel wird zur Bestimmung des mechanischen Verhaltens Sensordaten von Positions-, Drehwinkel- oder Drehzahlgebern ausgewertet, und unter Berücksichtigung von mechanischen Strukturdaten des Drehstrommotors das Massenträgheitsmoment $J$ des Rotors: $J = \int r^2 \rho(\vec{r}) dV$ mit $\rho(\vec{r})$ der Massendichte innerhalb des Volumens $V$ mit Abstand $r$ von der Drehachse des Rotors bestimmt. Moderne drehgeberlos geregelte elektrische Antriebe können allerdings nicht auf Sensordaten zurückgreifen, so dass im normalen Betrieb mechanische Kenngrößen nicht ermittelbar sind.

Die Massenträgheit $J$ gibt den Widerstand des Rotors bei Änderung seines Rotationszustands an, und beschreibt somit die Drehdynamik des Motors. Aus ihr lässt sich das Drehmoment $M$ mittels $M = \dot{\omega}J = \alpha J$ berechnen. Zur Bestimmung des Magnetflusses $\Psi_{PM}$ zwischen Stator und Läufer können Magnetfeldsensoren, beispielsweise Hall-Sensoren, AMR-Sensoren oder ähnliches eingesetzt werden, um die Größe der Magnetflussdichte B zu messen. Die Größe des Magnetflusses gibt

Auskunft über das maximal zu erreichende Drehmoment, das sich aus der Lorentzkraft $\vec{F} = I \cdot \vec{l} \times \vec{B}$ ergibt.

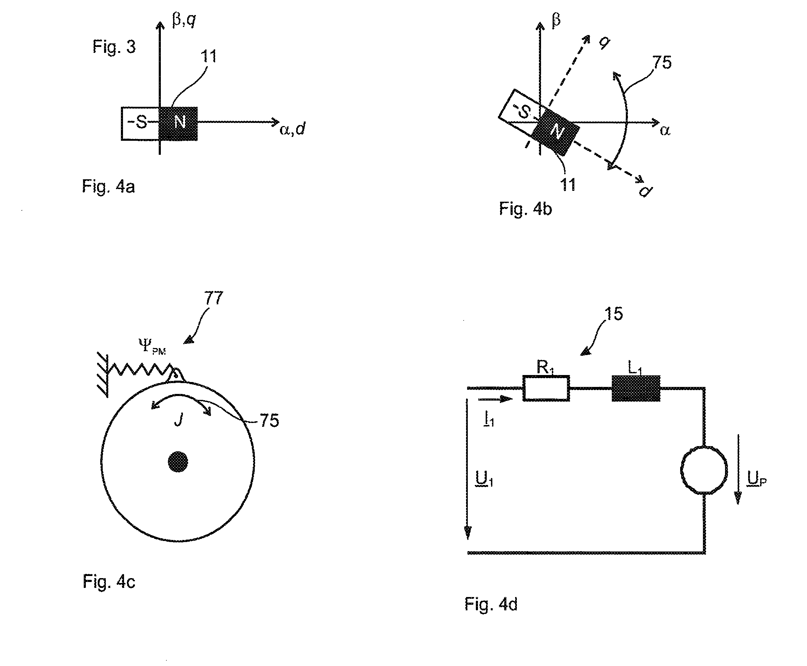

Ein Drehstrom-Synchronmotor umtasst einen Stator mit mindestens drei Statorspulen und einen Rotor mit einer Permanentmagnetisierung, die entweder durch Permanentmagnete hervorgerufen wird, oder durch mit Gleichstrom durchflossenen Spulen, die bürstenversorgt sind, erzeugt wird. Typischerweise verwendet man zur vereinfachten Charakterisierung des elektrischen Verhaltens eines Synchronmotors ein Ersatzschaltbild, wie es in Fig. 4d dargestellt ist, bei dem die Statorspule mittels eines ohmschen Widerstands $R_1$ und einer Induktivität $L_1$ sowie einer Spannungsquelle $U_p$ zur Berücksichtigung der induzierten Spannung nachgebildet wird. Zur Bestimmung von magnetomechanischen Größen kann eine Kenntnis elektrischer Größen vorteilhaft sein.

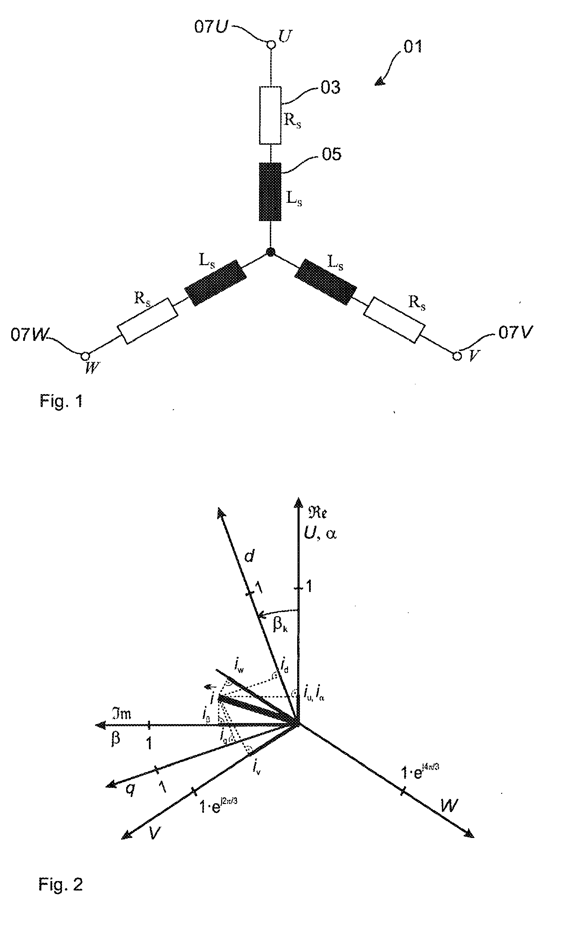

In einem Dreiphasensystem ergibt sich in Y- oder Δ-Schaltung durch Einspeisung zweier Phasen jeweils der Strom der dritten Phase nach der Regel $I_u + I_v + I_w = 0$ bei fehlender Sternpunktserdung. Aus diesem Grund lässt sich ein Dreiphasensystem auch mittels zweier Koordinaten in beschreiben, wobei zur Beschreibung des Gesamtstroms ein Koordinatensysterm in der komplexen Ebene betrachtet werden Kann, bei der die beiden Koordinaten Realteil und Imaginärteil als $\alpha$- und $\beta$-Koordinaten bezüglich der ortsfesten Ausrichtung des Statormagnetfelds bezeichnet werden können. Das $\alpha/\beta$-Koordinatensystem beschreibt beispielsweise die Richtung des Stromflusses oder die Rotorflußachse in dem ruhenden Bezugssystems des Stators des Drehstrommotors. Bezüglich des Läufers kann ein zweites sich drehendes Koordinatensystem eingeführt werden, dessen Achsen als $d$- und $q$-Achse des Rotors bezeichnet werden, wie es in Fig. 2 dargestellt ist. Die $d$-Achse bezeichnet die Hauptmagnetflussrichtung des Läufers und die $q$-Achse die hierzu rechtwinklige Querflussachse. Eine Ausrichtung eines Statormagnetfelds in Richtung der $d$-Achse des Rotors bewirkt quasi eine Feststellung des Rotors, während eine Stator-Magnetfeldausrichtung in Richtung der $q$-Achse des Rotors ein Drehmoment auf den Rotor bewirkt. Eine Transformation von $\alpha/\beta$-Statorkoordinatensystem in das sich drehende $d/q$-Rotorkoordinatensystem kann über den Drehwinkel $\beta_k$ zwischen der Wicklungsachse der Phase $U$ des Stators und der Längsachse des Rotormagnetfeldes hergestellt werden. Diesbezüglich können ein Gesamtmotorsrom $I$, bzw. dessen drei Phasenströme $I_U$, $I_V$ und $I_W$ im statorfesten $\alpha/\beta$-Koordinatensystem oder im sich mit dem Läufer drehenden $d/q$-Koordinatensystem betrachtet werden. Bezüglich der Umrechnung der Strangströme des Drehstrom-Synchronmotors in das $\alpha/\beta$-Koordinatensystem gilt folgender Zusammenhang:

$$\begin{pmatrix} i_\alpha \\ i_\beta \end{pmatrix} = \begin{pmatrix} 1 & 0 & 0 \\ 0 & \dfrac{\sqrt{3}}{3} & -\dfrac{\sqrt{3}}{3} \end{pmatrix} \begin{pmatrix} i_u \\ i_v \\ i_w \end{pmatrix}, \qquad\qquad \begin{pmatrix} i_u \\ i_v \\ i_w \end{pmatrix} = \begin{pmatrix} 1 & 0 \\ -\dfrac{1}{2} & \dfrac{\sqrt{3}}{2} \\ -\dfrac{1}{2} & -\dfrac{\sqrt{3}}{2} \end{pmatrix} \begin{pmatrix} i_\alpha \\ i_\beta \end{pmatrix},$$

der mittels Berücksichtigung des Läuferwinkels $\beta_K$ für das $d/q$-Koordinatensystem modifizierbar ist. Zur nachfolgenden mathematischen Erfassung der Zusammenhänge wird eine Betrachtung im $\alpha/\beta$-Statorkoordinatensystem nach Fig. 2 durchgeführt, wobei das in Fig. 4d dargestellte Ersatzschaltbild, eine Einphasen-Ersatzschaltbildcharakterisierung der Drehstrom-Synchronmaschine mit Speisespannungen- und Ströme $U_1$, $I_1$ sowie $U_2$/ $I_2$ beschreibt.

In der Fig. 4d ist das Ersatzschaltbild eines Synchronmotors bezüglich eines $\alpha/\beta$-Zeigerdiagramm dargestellt, wobei unter Kenntnis der genannten Ersatzschaltbildgrößen das elektrische Betriebsverhalten des Drehstrommotors in verschiedenen Betriebsfällen charakterisierbar ist:

$$U_{1\alpha} = R_1 \; I_{1\alpha} + L_1 \frac{dI_{1\alpha}}{dt} + U_P \sin(\beta_K) = R_1 \; I_{1\alpha} + L_1 \frac{dI_{1\alpha}}{dt} \underbrace{-\Omega_K \Psi_{PM}}_{U_P} \sin(\beta_K)$$

$$U_{1\beta} = R_1 \; I_{1\beta} + L_1 \frac{dI_{1\beta}}{dt} - U_P \cos(\beta_K) = R_1 \; I_{1\beta} + L_1 \frac{dI_{1\beta}}{dt} \underbrace{+\Omega_K \Psi_{PM}}_{-U_P} \cos(\beta_K)$$

mit $\beta_K = \int \Omega_K(t) dt = \Omega_K t$.

Die beiden Differentialgleichungen stellen im Frequenzbereich ein PT1-Verhalten mit dem Induktionsterm $U_P$ als Anregungsquelle dar, der wiederum von der Drehzahl und damit vom mechanischen Verhalten des Motors abhängt. Durch Messung elektrischer Größen lässt sich die Admittanz des Motors im Betriebsverhalten bestimmen, die sich nach folgender Gleichung ergibt:

$$G_{\alpha/\beta}(j\omega) = Y_{\alpha/\beta}(j\omega) = \frac{I_{1\alpha/\beta}(j\omega)}{U_{1\alpha/\beta}(j\omega)}$$

Ausgehend von den Phasenspsnnungen $U_U$, $U_V$ und $U_W$ und Strangströmen $I_U$, $I_V$ und $I_W$ werden diese gemäß der obigen Transformation in das $d/q$-Koordinatensystem überführt. Somit lässt sich das elektrische Verhalten der Drehstrom-Synchronmaschine mit Hilfe der Eingangsgröße $U_1$ und Ausgangsgröße $I_1$ betrachten. Diesbezüglich lassen sich getrennte Betrachtungsweisen bezüglich der $\alpha$- und $\beta$ - bzw. $d$-/$q$-Achse durchführen, so dass sich beispielsweise bezüglich der $d$-Achse eine Übertragungsfunktion, beziehungsweise Admittanz ergibt mit

$$G_1 = I_{1d}/U_{1d}.$$

Durch Bestimmung der Übertragungsfunktion $G_1$ können unbekannte Parameter der Übertragungsfunktion bestimmt werden. Es gibt beispielsweise Überlegungen, durch einen ähnlichen Ansatz unter Annahme eines Rotorstillstands ($n=0$ -> $U_p=0$) die elektrischen Ersatzschaltbildgrößen $L_1$, $R_1$ zu bestimmen.

Aus dem Stand der Technik ist zur Bestimmung mechanischer Kenngrößen eines Drehstrommotors, insbesondere zur Fehlerdiagnose mechanischer Teile oder zur mechanischen Systemidentifikation beim Betrieb in einem mechanischen Verband bekannt, ein Pseudo-Rausch-Binar-Signals (PRBS) als elektrische Testanregung einzusetzen. Dabei stellt das mechanische System ein SISO-System (Single-Input Single-Output) dar, bei der mit Hilfe einer einzigen mechanischen oder elektrischen Eingangsgröße eine einzige mechanische Ausgangsgröße mittels eines mechanischen Drehgebers gemessen werden kann. Die Eingangsgröße wird mit Hilfe des Pseudo-Rausch-Binär-Signals angeregt, so dass in der Ausgangsgröße ein breitbandiges Verhalten des SISO-Systems bestimmt werden kann. Mit Hilfe signaltheoretischer Methoden der Frequenztransformation und Parameteridentifikation anhand des Frequenzverhaltens können Kenngrößen des mechanischen Systems bei Kenntnis der zugrundeliegenden Systemgleichung abgeleitet werden,

Im Falle einer Bestimmung magnetomechanischer Kenngrößen basierend auf Einspeisung und Messung rein elektrischer Größen handelt es sich allerdings um ein sogenanntes MIMO-System (Multiple-Input Multiple-Output), bei dem mehrere Eingangsgrößen (Strangspannungen) eingespeist und mehrere Ausgangsgrößen (Strangströme) extrahiert werden müssen. Aus diesem Grund können die aus dem Verfahren zur Identifikation mechanischer Größen bekannten Methoden nicht für die elektrische Systemcharakterisierung eines Drehstrommotors angewendet werden. Die Identifikation des mechanischen Systems ist umfassend in der Dissertation von Sebastian Villwock. "Identifikationsmethoden für die automatisierte Inbetriebnahme und Zustandsüberwachung elektrischer Antriebe", Universität Siegen, 2007, (Druckschrift [1]) beschrieben. Des Weiteren ist eine diesbezüglich verwendete signaltheoretische Methode für die Parameteridentifikation eines mechanischen Systems in dem Zeitschriftenbeitrag: S. Villwock, J. M. Pacas: "Application of the Welch-Method for the Identification of Two and Three Mass Systems", IEEE Transactions on Industrial Electronics, Vol. 55, No. 1, Januar 2008, S. 457-466 (Druckschrift [2]) beschrieben. Ein gattungsähnliches Verfahren ist im Rahmen eines Konferenzartikels in: P. Szczupak, J. M. Pacas: "Automatic Identification of a PMSM Drive Equipped with an Output LC-Filter", IEEE Industrial Electronics, IECON 2006, 32nd Annual Conferenee on November 2006, S, 1143-1148 (Druckschrift [3]) vorgestellt.

Aufgabe der vorliegenden Erfindung ist es, ausgehend von einem elektrischen Ersatzschaltbild einer Drehstrom-Synchronmaschine ein Verfahren zur Bestimmung von magnetomechanischen Kenngrößen, insbesondere des Massenträgheitsmoment $J$ des Rotors und Antriebsstrangs und des Permanentmagnetflusses $\Psi_{PM}$ zwischen Rotor und Stator vorzuschlagen, wobei eine Parameteridentifikation ohne Drehgebersensoren ermöglicht wird, der Rotor nur geringe Auslenkungsbewegungen mit vordefinierbaren Maximalamplituden ausführt und durch eine einzige Messung die magnetomeohanischen Kenngrößen ermittelt werden können. Vorteilhafte Fortbildungen der Erfindung sind Gegenstand der Unteransprüche.

Eine weitere Aufgabe der Erfindung besteht darin, eine Vorrichtung zur drehgeberlosen Identifikation vorzuschlagen, bei der die Identifikation der magnetömechanischen Kenngrößen nur über Messung elektrischer Größen vornehmbar ist, so dass keine Sensoren zur Bestimmung des magnetischen oder mechanischen Verhaltens der Synchronmaschine mit angeschlossenem Abtriebsstrang herangezogen werden müssen.

OFFENBARUNG DER ERFINDUNG

In einem ersten Aspekt der Erfindung wird ein Verfahren nach Anspruch 1 vorgeschlagen.

Die Testsignaleinspeisung und Meßsignalmessung erfolgt durch die Einspeisung von Statorspannung und Messung von Statorströmen im U/V/W-System. Die Spannungen werden allerdings bezüglich einer bekannten Lage der $d$-Hauptmagnetflussachse des Rotors durchgeführt. Die Richtung der $d$-Achse kann beispielsweise durch einen mechanischen Anschlag, durch einen Drehwinkelsensor oder durch gezielte Ausrichtung bzw, Rastlagensuche des Rotors gegenüber den $\alpha/\beta$-Achsen des Stators festgestellt bzw. definiert werden. Die resultierenden Frequenzgangdaten enthalten die Information über zumindest die mechanische Kenngröße $J$ (Massenträgheitsmoment) und magnetische Kenngröße $\Psi_{PM}$ (Permanentfluss), wobei das erfindungsgemäße Verfahren die Identifikation des Massenträgheitsmoments $J$ und des magnetischen Permanentfusses $\Psi_{PM}$ für einen Synchronmotor, insbesondere für einen permanentmagneterregten Synchronmotor (PMSM), allein auf Basis der elektrischen Größen Spannung und Strom ermöglicht. Dabei berücksichtigt das Verfahren sowohl das Massenträgheitsmoment $J$ des Motors als auch eines eventuell mechanisch gekoppelten Abtriebsstrangs, beispielsweise Getriebe und bewegte Maschinenteile einer angeschlossenen Maschine.

Eine Auslenkungsbewegung mit vordefinierbaren Maximalamplituden des Motors bedeutet, dass sich der Winkel des Rotors gegenüber dem Stator nur in einem vorbestimmbaren Winkelmaß andert, so dass keine vollständige Drehung des Rotors erfolgen kann und der Rotor in einem definierbaren Winkelbereich gegenüber dem Stator ausgerichtet bleibt. Die Maximalamplituden dürfen nur so groß ausfallen, dass die Vereinfachung angenommen werden kann, dass der Rotor stillsteht, wodurch das $d/q$-Achsensystem gegenüber dem $\alpha/\beta$-Achsensystem feststehend angesehen werden kann, Nach Einnahme einer Stillstandslage des Rotors wird eine Testsignalspannung in die $q$-Flussachsenrichtung des Rotors eingespeist und der sich ergebende Meßsignalstrom $I_{1q}$ gemessen. Eine Konstantstromeinprägung $I_{1d}$ in $d$-Achsenrichtung bewirkt eine Ausrichtung des Rotors gegenüber dem Stator, wobei kein Drehmoment auf den Rotor ausgeübt wird. Der Rotor bildet ein Feder-Masse-System, wie in Fig. 4 dargestellt, wobei das in $d$-Richtung eingespeiste Magnetfeld eine Ruckstellung bewirkt und der in $q$-Richtung eingespeiste Strom eine Anregung des Systems bewirkt. Die Masse entspricht dem Trägheitsmoment des Rotors bzw. Antriebsstrangs. Der mechanische Antriebsstrang besteht aus dem Rotor der elektrischen Antriebsmaschine und einer gegebenenfalls angekoppelten mechanischen Last einschließlich Getriebe, Wellen und ähnliches. Die Struktur des Testsignals $U_{1q}$ bestimmt, welche Frequenzkomponenten oder -bereiche messbar sind und mit welcher Genauigkeit die Ersatzschaltbildparameter identifiziert werden können, wobei Kenngrößen entsprechend der Frequenzabdeckung des Testsignals extrahiert werden können. Eine Einspeisung der Testspannung $U_{1q}$ erzeugt einen Meßsignalstrom $I_{1q}$, der gemessen werden kann. Zusätzliche Messtechnik ist nicht erforderlich, da die vorgegebenen Sollspannungen in Form des Testsignals beispielsweise in einem Controller oder Signalprozessor (DSP) einer motoransteuernden Wechselrichteinrichtung erzeugt werden kann, und die Ströme zur Stromregelung ohnehin gemessen werden, obwohl hier eine mechanische Größe identifiziert wird.

Im Gegensatz zu einem Asynchronmotor würde es bei einer identischen Einspeisung eines Testsignals in beide Rotorachsrichtungen $d$ und $q$ zu einer unkontrollierbaren Drehmomentbildung und somit zu einer unkontrollierten mechanischen Bewegung der Motorwelle kommen. Um diese zu vermeiden kann zunächst eine Rastlagesuche oder Ausrichtung der d-Achse gegenüber den $\alpha/\beta$-Achsen des Stators durchgeführt werden. damit die Lage der $d$-Flussachse bekannt ist. Im Unterschied zur Asynchronmaschine erfolgt anschließend die Frequenzgangmessung durch Einspeisung des Testsignals ausschließlich in $q$-Richtung, da die $q$-Komponente des Statorstroms $I_{1q}$ zur Drehmomentbildung beiträgt. Die Rastlagesuche kann vermieden werden, indem die Bestromung der Maschine in $\alpha$-Richtung mit einem Gleichstrom erfolgt. Dann richtet sich der Rotor an der $\alpha$-Achse aus, so dass $\alpha$- und $d$-Achse übereinstimmen. Somit kann das Testsignal über die $\alpha$-Achse, die jetzt mit der $d$-Achse übereinstimmt, in den Drehstrommotor eingespeist werden. Im Ergebnis kann der Rotor in $d$-Achsenrichtung quasi festgestellt werden, wobei die Konstantbestromung in $d$-Richtung eine Rückstellwirkung bewirkt, so dass eine Testsignaleinspeisung in $q$-Richtung zwar Rotorbewegungen ermöglicht, jedoch durch die Rückstellwirkung eine Rückkehr in eine definierbare Rotorposition gegeben ist. Alternativ kann, falls die Rastlage alias Pollage der Synchronmaschine a priori bekannt ist, das Testsignal direkt als Spannung $U_{1q}$ und die Konstantspannung $U_{1d}$ geeignet in die Statorwicklungen eingespeist werden.

Die Einspeisung der Strangspannung zur Messung des Strangstroms kann beispielsweise mittels eines 2/3-Phasen-Konverters erfolgen, der obiger Matrixrelation folgend und unter Beachtung des Rotordrehwinkels $\beta_k$ aus den beiden Spannungen $U_{1d}$ und $U_{1q}$ die drei Phasenspannungen $U_U$, $U_V$ und $U_W$ erzeugen bzw. aus den drei gemessenen Strömen $I_U$, $I_V$ und $I_W$ die beiden Ströme $I_{1d}$ und $I_{1q}$ transformieren kann. Eine Einspeisung des Testsignals kann beispielsweise durch eine Steuerung eines Wechselrichters der Motorsteuerungsvorrichtung des Drehstrommotors erfolgen. Alternativ kann die Testsignalspannung direkt in die Stränge der Synchronmaschine entsprechend der Lage der $d$-Achse eingespeist werden. Die Messung der Strangströme kann über die selben Strommessinstrumente erfolgen, die bei einer drehgeberlosen Regelung im Betrieb des Drehstrommotors verwendet werden. Im Zeitbereich können die eingespeisten Testsignalspannungen und die gemessenen Meßsignalströme als digital erfasste zeitliche Abtastwerte aufgezeichnet werden, und auf deren Basis können die Kenngrößen extrahiert werden. Dies erfolgt bevorzugt durch eine Frequenzbereichsanalyse, d.h. einer Frequenztransformation der aufgezeichneten Zeitbereichsdaten, und einer Analyse des Frequenzgangs der gemessenen Übertragungsfunktion $G_1$. Unter Kenntnis der vorgenannten Admittanzfunktion, die als Übertragungsfunktion im Frequenzbereich dargestellt werden kann, können die Koeffizienten und damit die einzelnen Parameter der Übertagungsfunktion mittels einer geeigneten signaltheoretischen Methode ermittelt werden, wobei diese Parameter zur Identifikation der magnetomechanischen Kenngrößen herangezogen werden können.

Eine Bestimmung des Frequenzgangs der Übertragungsfunktion $G$ unter Kenntnis der zugrunde liegenden Admittanz-Formel $\underline{Y}$ ermöglicht die Extraktion der magnetomechanischen Kenngrößen. Somit kann durch eine Einspeisung eines insbesondere breitbandigen Testsignals mittels einer einzigen Messung Aussagen über die magnetischen und mechanischen Kenngrößen des Drehstrommotors getroffen werden. Hierzu werden signaltheoretische Methoden herangezogen, die die gemessenen Zeitbereichsdaten in Frequenzbereichsdaten transformieren, wobei der Frequenzgang formeimäßig erfasst werden kann, und mittels einer Parameterextraktion aus dem Frequenzgang die Parameter der zugrundeliegenden Übertragungsfunktion und damit die Ersatzschaltbildgrößen identifiziert werden können.

Grundsätzlich kann statt einer Testspannungsvorgabe und Meßstrombestimmung auch eine Teststromvorgabe mit Meßspannungserfassung erfolgen Allerdings weisen insbesondere leistungsstarke Motoren ein hochinduktives Verhalten auf, so daß zur Einprägung rechteckförmiger Stromschaltimpulse hohe Treiberspannungen angelegt werden müßten, worduch eine Teststromeinprägung nur mit hohem Aufwand möglich ist.

Gemäß einer vorteilhaften Weiterbildung der Erfindung kann unter Kenntnis der Lage der $d/q$-Rotorachsenrichtungen gegenüber den $\alpha/\beta$-Statorachsenrichtungen eine entsprechende $U_{1\alpha}$, $U_{1\beta}$ Einspeisung erfolgt, so dass in $d$-Flussachsenrichtung ein konstantes Statormagnetfeld und in $q$-Querflussachsenrichtung eine Testsignateinspeisung durchführbar ist. Durch eine Lagekenntnis der $d$-Rotorachse zur $\alpha$-Statorachse ist der Rotorlagenwinkel $\beta_k$ bekannt, so dass an die Statorwicklung eine Konstantspannung sowie eine drehmomentbildende Meßspannung eingeprägt werden kann, um den Rotor gezielt in Messschwingungen um den Rotortagenwinkel $\beta_k$ zu versetzen.

Besonders vorteilhaft kann die $d$-Flussachsenrichtung des Rotors gegenüber der $\alpha$-Achse des Stators ausgerichtet sein, so dass der Rotorlagenwinkel $\beta_k=0$ beträgt. Durch eine Konstantspannungseinspeisung $U_{1\alpha}$ in $\alpha$-Achsenrichtung des Stators kann eine Ausrichtung der $d$-Flussachse des Rotors bezüglich der $\alpha$-Achse des Stators durch Einprägung eines Gleichstroms $I_{1\alpha}=I_{DC}$ bewirkt werden; und eine Testsignalspannungseinspeisung $U_{1\beta}$ in $\beta$-Achsenrichtung, erfolgen, wobei die $\alpha$-Achsenrichtung DCbestromt bleibt; so dass ein Meßsignalstrommessung $I_{1\beta}$ der $\beta$-Achsenrichtung messbar ist. Eine Konstantbestromung in $\alpha$-Achsrichtung bewirkt somit eine Ausrichtung der $d$-Flussachsenrichtung, wobei der Rotor drehmomentfrei bleibt. Ist die Rotorruhelage, d.h. $\beta_k$ bekannt, beispielsweise durch einen definierten mechanischen Anschlag oder eine Lageinformation durch einen Drehwinkelsensor, so kann eine Konstantbestromung der Statorwicklungen in Lagerichtung der $d$-Rotorachse erfolgen. Auch kann eine Konstantbestromung der Statorspulen in einer beliebigen Lage eine Ausrichtung der $d$-Achse in die Achse des sich einstellenden Statormagnetfelds erzwingen. Ein Verfahren zur Rastlagensuche ist in vielen aus dem Stand der Technik bekannten Motorsteuerungsvorrichtungen bereits implementiert.

Im Fall einer Ausrichtung von $d$- zur $\alpha$-Achse ergeben sich die im Folgenden formelmäßig dargelegten Vereinfachungen, so dass die magnetomechanischen Kenngrößen besonders einfach identifizierbar sind. Durch Einspeisung einer Konstantspannung $U_{1\alpha}$ = konstant, z.B. 10 V wird die Maschine in die Flussachse ($d$-Achse) orientiert, wobei sich die Welle der Maschine evtl. bewegt. Die $\alpha$-Achse entspricht jetzt der $d$-Achse und die $\beta$-Achse entspricht jetzt der $q$-Achse. Diese Konstanteinspeisung muss während der gesamten Identifikationsprozedur aufrecht erhalten werden, d.h. auch während das Testsignal eingespeist wird, wie nachfolgend erörtert wird. Somit kann eine federähnliche Wirkung erzeugt werden. Mit der Einspeisung eines geeigneten $U_{1\beta}$-Testsignals in die $\beta$-Achse, d.h. $q$-Achse in diesen Fall, wird die stabile Lage des Rotors gestört und es kommt zu einer Auslenkung und damit zu einem Drehmoment. Der konstante Strom $I_{1\alpha}$ wirkt dagegen und wird den Rotor wieder in die Flussachse ziehen wollen.

Hierbei gelten folgende Modellgleichungen:

Spannungsgleichungen im statorfesten Bezugssystem:

$$U_{1\alpha} = R_1 \quad I_{1\alpha} - \Omega_K \quad \Psi_{PM} \cdot \sin\left(\beta_K\right) + L_1 \cdot \frac{dI_{1\alpha}}{dt}$$

$$U_{1\beta} = R_1 \quad I_{1\beta} + \Omega_K \quad \Psi_{PM} \cdot \cos\left(\beta_K\right) + L_1 \cdot \frac{dI_{1\beta}}{dt}, \; mit \;\; \beta_K = \Omega_K \cdot t$$

Durch die Einspeisung $U_{1\alpha}$ = konstant gilt $\alpha$-Achse = $d$-Achse für kleine Auslenkungen:

$$\rightarrow \; \beta_K \approx 0 ,$$

$$\rightarrow \; \sin\left(\beta_K\right) \approx \beta_K \; und \;\; \cos\left(\beta_K\right) \approx 1 .$$

Damit ergeben sich die Spannungsgleichungen zu

$$U_{1\alpha} = R_1 \quad I_{1\alpha} - \Omega_K \quad \Psi_{PM} \cdot \beta_K + L_1 \cdot \frac{dI_{1\alpha}}{dt}$$

$$U_{1\beta} = R_1 \quad I_{1\beta} + \Omega_K \quad \Psi_{PM} \cdot 1 + L_1 \cdot \frac{dI_{1\beta}}{dt}$$

Annahme $I_{1\alpha}$= konstant ergibt:

$$U_{1\alpha} = R_1 \quad I_{1\alpha} - \Omega_K \quad \Psi_{PM} \cdot \beta_K$$

$$U_{1\beta} = R_1 \quad I_{1\beta} + \Omega_K \quad \Psi_{PM} + L_1 \cdot \frac{dI_{1\beta}}{dt} \cdot$$

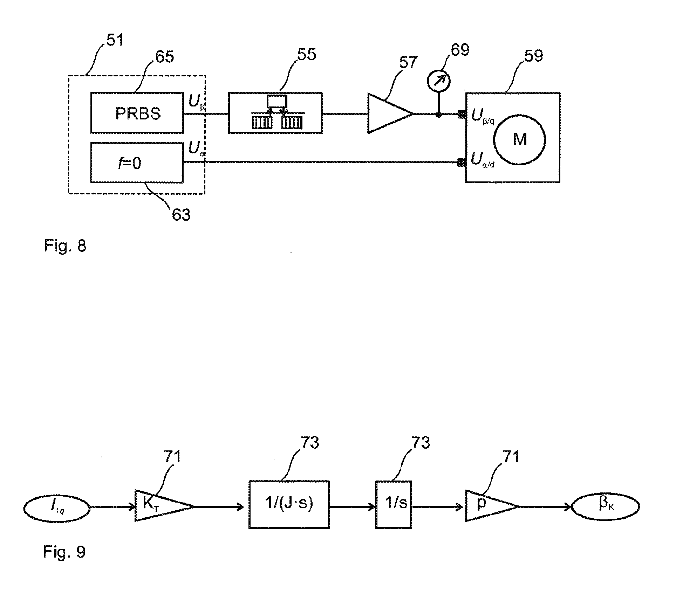

Nun folgt die Herleitung des Zusammenhangs zwischen Rotorwinkel $\beta_k$ und Meßsignalstrom $I_{1q}$: Den Ausgangspunkt der Betrachtung bildet das in Fig. 9 dargestellte Blockschaltbild: Die Eingangsgröße des Blockschaltbildes ist die drehmomentbildende Komponente des Statorstroms $I_{1q}$. Die Ausgangsgröße ist der Winkel $\beta_k$ der Flussverkettung der Permanentmagnete im ständerfesten $\alpha$ /$\beta$-Koordinatensystem $\beta_k$, wobei p die Polpaarzahl bedeutet.

Für die Drehmomentkonstante $K_T$ gilt der Zusammenhang:   $K_T = \dfrac{3}{2} \quad p \quad \Psi_{PM}$   Damit gilt

$$\beta_K = K_T \quad \frac{1}{s \quad J} \quad I_{1q} \quad \frac{1}{s} \quad p$$

Zudem gilt im flussfesten Koordinatensystem

$$I_{1q} = I_{1\beta} \cos\left(\beta_K\right) - I_{1\alpha} \sin\left(\beta_K\right).$$

$$\blacktriangleright \quad \beta_K = \frac{K_T \quad p}{s^2 \quad J} \left[ I_{1\beta} \cos\left(\beta_K\right) - I_{1\alpha} \sin\left(\beta_K\right) \right]$$

Für kleine $\beta_k$ folgt die Vereinfachung:

$$\beta_K = \frac{K_T \quad p}{s^2 \quad J} \left[ I_{1\beta} - I_{1\alpha} \beta_K \right]$$

$$\Rrightarrow \quad \beta_K = \frac{K_T \quad p \quad I_{1\beta}}{s^2 \quad J + K_T \quad p \quad I_{1\alpha}}$$

Mit $\Omega_K = \dfrac{d\beta_K}{dt}$ bzw. $\Omega_k = s\beta_k$ erhält man

$$\Omega_K = \frac{K_T \quad p \quad I_{1\beta} \quad s}{s^2 \quad J + K_T \quad p \quad I_{1\alpha}}$$

Für die $\beta$-Spannungsgleichung ergibt sich nun:

$$U_{1\beta} = R_1 \quad I_{1\beta} + \quad \Psi_{PM} \cdot \frac{K_T \quad p \quad I_{1\beta} \quad s}{s^2 \quad J + K_T \quad p \quad I_{1\alpha}} + L_1 \cdot I_{1\beta} \cdot s = \left[ R_1 \quad + \quad \Psi_{PM} \cdot \frac{K_T \quad p \quad s}{s^2 \quad J + K_T \quad p \quad I_{1\alpha}} + L_1 \cdot s \right] \cdot I_{1\beta}$$

Man erhält folgende Übertragungsfunktion:

$$G_\beta(s) = \frac{I_{1\beta}(s)}{U_{1\beta}(s)} = \frac{s^2\,J + K_T\,p\,I_{1\alpha}}{s^3\,J\,L_1 + s^2\,J\,R_1 + s\left(L_1\,K_T\,p\,I_{1\alpha} + \Psi_{PM}\,K_T\,p\right) + R_1\,K_T\,p\,I_{1\alpha}}$$

Diese Übertragungsfunktion erhält nur 2 Unbekannte, die im Rahmen dieser Identifikation zu ermittelnde magnetomechanischen Kenngrößen $J$, $\Psi_{PM}$, wobei die Massenträgheit in dem Term $K_T$ enthasten ist. Die Übertragungsfunktion lässt sich in der Form:

$$G_\beta(s) = \frac{I_{1\beta}(s)}{U_{1\beta}(s)} = \frac{a_2 s^2 + a_0}{b_3 s^3 + b_2 s^2 + b_1 s + b_0}$$

schreiben Durch Transformation des eingespeisten Testsignats $U_{1\beta}$ und des gemessenen Meßsignalstrorns $I_{1\beta}$ in den Laplacebereich kann obenstehende Übertragungsfunktion durch Division gebildet werden und mittels üblicher Identifkationsverfahren die Koeffizienten $a_0$, $a_2$, $b_0$, $b_1$ und $b_2$ bestimmt werden. Aus diesen können unter dem Wissen, dass $a_0 = K_1 p I_{1\alpha}$, $a_2 = J$, $b_0 = R_1 K_T p I_{1\alpha}$, $b_1 = L_1 K_T p I_{1\alpha} + \Psi_{PM} K_T p$, $b_2 = J L_1$ ist, die Parameter Massenträgheit $J$ des mechanischen Systems sowie Permanentmagnetfluss $\Psi_{PM}$ bestimmt werden.

Gemäß einer vorteilhaften Weiterbildung kann das Verhältnis von Konstantspannung $U_{1d}$ zur Testsignalspannung $U_{1q}$ derart optimiert wählbar ist, um Maximalamplituden der Audenkungsbewegung in einer Höhe zu erreichen, so dass magnetomechanische Kenngrößen eines einstellbaren Feder-Masse-Systems mit einer vorbestimmbaren Genaulgkeit ermittelt werden können. Während der Einspeisung des Testsignals in die $d$- Rotorkoordinatenrichtung wird kein Drehmoment in der Maschine erzeugt, so dass der Rotor zunächst drehmomentfrei in seiner Lage verbleibt. Dabei ist die Konstantspannung $U_{1d}$ in einer Größe zu wählen, so dass der Rotor "federnd" in seine Ruhelage bei Einspeisung des Testsignals in $q$-Richtung zurückkehren kann. Eine zu geringe Konstantspannung würde zu einer ungewollten Verdrehung des Rotors gegenüber dem Stator führen, so dass keine gezielte $d/q$-Bestromung durchführbar wäre. Eine zu hohe Konstantspannung gegenüber der Testsignalspannung $U_{1q}$ würde zu einer Feststellung des Stators führen, so dass keine mechanische Bewegung und somit keine Selbstinduktion auftreten würde. Folglich könnten in beiden Fällen keine mechanischen Kenngrößen ermittelt werden. Somit ist es wichtig, dass die Amplituden der Konstantspannung und des Testsignals in einem angemessenen Verhältnis stehen. Wäre die Konstantspannung in der $d$-Achse deutlich zu groß, wäre die Wirkung wie eine mechanisch festgebremste Maschine. Das hier beschriebene Verfahren beruht darauf, dass die Maschine sich aus der Flussachse heraus bewegen und selbständig darin zurückkehren kann. Hierzu kann es vorteilhaft denkbar sein, das Verhältnis von Konstantspannung $U_{1d}$ zur Testsignalspannung $U_{1q}$ und/oder die Höhe der Konstantspannung $U_{1d}$ zu variieren und jeweils Parameteridentifikationen mit geänderten Spannungswerten durchzuführen, wobei die sich ergebenden Parameter als Durchschnitt oder gewichteter Parameter aus den Ergebnissen der einzelnen Parameteridentifikationen ermittelbar sein können. Somit können Fehler in der Bestimmung vermindert werden, so dass ein genaueres Ergebnis erzielt werden kann.

Gemäß einer vorteilhaften Weiterbildung können zur Identifikation der magnetomechanischen Kenngrößen weitere Kenngrößen, insbesondere Ersatzschaltbildkenngrößen $L_1$, $R_1$ sowie mechanische Strukturgrößen wie Polpaarzahl p und/oder elektrische Meßgrößen wie $I_{1\alpha}$, $I_{1\beta}$, insbesondere $I_{1\alpha} = I_{DC}$ des Synchronmotors berücksichtigt oder ebenfalls identifziert werden. Den obigen Formelzusammenhängen folgend werden zur Bestimmung der Massenträgheit J und des Permanentmagnetflusses $\psi_{PM}$ die Kenntnis von Polpaarzahl $p$, Ersatzschaltbildparameter $L_1$, $R_1$, sowie Größe des Feststellstroms $I_{1\alpha}$ benötigt. Diese Werte können strukturell definiert, empirisch festgelegt oder messtechnisch erfasst werden. Für eine messtechnische Erfassung insbesondere der Ersatzschaltbildparameter $L_1$, $R_1$ bietet sich eine verwandte Parameteridentifikation der elektrischen Ersatzschaltbildparameter auf Basis einer gezielten Testsignaleinspeisung an, die Gegenstand einer parallelen Patentanmeldung ist, und bei der ein Testsignal in $d$-Richtung eingespeist wird, wobei die $q$-Richtung unbestromt bleibt. Daneben können die Kenngrößen oder Ersatzschaltbildparameter, die in den Koeffizienten der Übertragungsfunktion charakterisiert sind, ebenfalls im Rahmen der Parameteridentifikation bestimmt werden. So ist denkbar, aus den bestimmten Koeffizienten der Übertragungsfunktion alle in die Übertragungsfunktion einfließenden Parameter, zumindest jedenfalls die elektrischen Ersatzschaltbildparameter zu extrahieren.

Gemäß einer vorteilhaften Weiterbildung kann das Testsignal ein Pseudo-Rausch-Binär-Signal sein. Das Testsignal sollte eine hohe Bandbreite aufweisen, um eine möglichst hohe Frequenzauflösung des elektrischen Motorverhaltens zu ermöglichen. Weißes Rauschen besitzt ein gleichverteiltes breitbandiges Frequenzspektrum. Ein Pseudo-Rausch-Binär-Signal (PRBS) ist ein binäres Signal, welches das Spektrum von weißem Rauschen approximiert. Es kann typischerweise die Werte +1 und -1 annehmen und wird alternativ zum weißen Rauschen verwendet. Vorteilhaft ist insbesondere die Reproduzierbarkeit des Signals, wobei häufig in der Regelungstechnik ein PRB-Signal zur Analyse eine Impulsantwort mittels einer Maximum-Length-Sequence verwendet wird. Ein PRB-Testsignal lässt sich leicht durch linear rückgekoppelte Schieberegister erzeugen und kann beispielsweise durch einen DSP (Digital Signal Processor), FPGA (Field Programmable Gate Array) oder Mikrocontroller eines Motorreglers zur Ansteuerung des Wechselrichters erzeugt werden. Somit kann jede Motoransteuerelektronik solch ein PRB-Signal ohne größere Modifikation erzeugen und als Motorspannung in den Motor einspeisen.

Grundsätzlich kann eine Frequenzbereichstransformation von abgetasteten Zeitbereichsdaten zur Identifikation der Ersatzschaltbildparameter im Frequenzbereich beliebig erfolgen. Gemäß einer vorteilhaften Weiterbildung der Erfindung kann die Identifikation der Ersatzschaltbildparameter eine Fouriertransformation nach einem Periodogramm-Verfahren, bevorzugt ein Bartlett-Verfahren, insbesondere einem Welch-Verfahren umfassen. Im Rahmen eines Periodogramm-Verfahrens wird eine spektrale Leistungsdichte durch eine Fourier-Transformation einzelner Datenblöcke erreicht. Die Qualität der Spektralschätzung kann verbessert werden, indem eine Anzahl voneinander unabhängiger Periodogramme gemittelt wird. Dieses Verfahren ist in der Literatur unter dem Namen Bartlett-Methode bekannt, bei dem das gemessene Signal in Abschnitte aufgeteilt wird. Die Welch-Methode stellt eine Erweiterung der von Bartlett vorgeschlagenen Vorgehensweise dar. Zur Reduzierung des Leck-Effekts (engl. *Leakageeffect)* kommen hier bestimmte Fensterfunktionen zum Einsatz. Der störende Leck-Effekt tritt dann auf, wenn der Signalabschnitt nicht periodisch, ein ganzzahliges Vielfaches der Periode oder dieser Signalabschnitt an den Rändern von null verschieden ist. Die Anwendung eines Welch-Verfahrens bei der Identifikation eines Zwei- oder Dreimassensystems ist bereits aus der oben genannten Druckschrift [2] bekannt. Das Welch-Verfahren spaltet M-Abtastwerte in K-Teilfolgen auf, die mit einer Fensterfunktion gewichtet werden, und auf die eine Fouriertransformation angewendet wird. Die in der Druckschrift [1] beschriebene Welch-Methode ermöglicht die Transformation einer beliebigen Zahl von Abtastwerten mit einer möglichst hohen Genauigkeit in den Frequenzbereich. Hierbei werden die Zeitbereichsdaten gefenstert, die gefensterten Daten in Teilfolgen aufgeteilt und fouriertransformiert, und hieraus Periodigramme ermittelt, die zur Bestimmung der Übertragungsfunktion, in diesem Fall der Admittanz-Funktion, im Frequenzbereich herangezogen werden können.

Alternativ hierzu kann allerdings auch eine Korrelogramm-Methode, die in der Literatur auch unter dem Namen Blackman-Tukey-Schätzung bekannt ist, eingesetzt werden Dabei erfolgt die Spektralschätzung auf Grundlage einer Autokorrelationsfunktion (AKF) und einer Kreuzkorrelationsfunktion (KKF), die aus dem Testsignal (Anregungssignal) und dem Meßsignal (Antwortsignal) berechnet wird. Bei diesem Ansatz erhält man die spektrale Leistungsdichte durch Fourier-Transformation der zuvor geschätzten AKF und KKF. Die Welch-Methode liefert allerdings robustere Ergebnisse.

Ausgehend von der im Frequenzbereich vorliegenden Darstellung einer bekannten Übertragungsfunktion, beispielsweise des Admittanzverlaufs, können die magnetomechanischen Kenngrößen des Drehstrommotors extrahiert werden. Hierzu gibt es bereits einige numerische Ansätze. Besonders vorteilhaft kann der Levenberg-Marquardt-Algorithmus in einer Weiterbildung der Erfindung verwendet werden, um zunächst die Übertragungsfunktionskoeffizienten $a_0$, $a_2$, $b_0$, $b_1$ und $b_2$, die diesen zugrundeliegenden Parameter und darauf aufbauend die magnetomechanischen Kenngrößen zu identifizieren. Alternativ kann beispielsweise ein Verfahren nach Nelder und Mead verwendet werden, wobei allerdings der Levenberg-Marquardt-Algorithmus, insbesondere bei stark verrauschten Datensätzen, robustere Ergebnisse liefert. Er gehört zur Gruppe von Gradienten-Verfahren, wobei durch iteratives Minimieren einer Fehlerfunktion bessere Parametervektoren berechnet werden können, die den Koeffizienten der Übertragungsfunktion entsprechen. Das Levenberg-Marquardt-Verfahren gilt mornentan als Standardverfahren für nicht lineare Optimierungen. Es ist eine Mischung aus Gradienten-Verfahren und Inversion einer Hesse-Matrix und wird in der Literatur auch als Methode des steilsten Abstiegs bezeichnet. Die Inversion der Hesse-Matrix wird auch als Gauss-Newton-Verfahren bezeichnet. In Druckschrift [1] ist eine detaillierte Darstellung der Anwendung des Levenberg-Marquardt-Algorithmus vorgestellt, wobei ausgehend von einer Übertragungsfunktion:

$$G = \underline{Y} = \frac{a_2 s^2 + a_0}{b_3 s^3 + b_2 s^2 + b_1 s + b_0}$$

und unter Vorlage des Frequenzgangs des Systems die unbekannten Koeffizienten $a_0$, $a_2$, $b_0$, $b_1$ und $b_2$ bestimmt werden können. Im Vergleich mit der oben genannten Admittanzdarstellung entsprechen diese den elektrischen und magnetomechanischen Parametern. $a_0 = K_T p I_{1\alpha}$, $a_2 = J$, $b_0 = R_1 K_T p I_{1\alpha}$, $b_1 = L_1 K_T p I_{1\alpha} + \Psi_{PM} K_T p$, $b_2 = J L_1$. Durch die Ermittlung dieser Parameter lassen sich somit die Kenngrößen der Massenträgheit $J$ und des Permanentmagnetflusses $\Psi_{PM}$ ermitteln.

Gemäß einer vorteilhaften Weiterbildung der Erfindung können die identifizierten Kenngrößen bei einer Einstellung und/oder Optimierung von Wechselrichter-Steuerparametern und/oder zur Motorüberwachung verwendet werden. Bei der Regelung moderner Synchronmaschinen werden Motorsteuerungsvorrichtungen eingesetzt, die bei schnellen Drehzahlübergängen oder bei Bereitstellung dynamisch regelbarer Abtriebsenergie aufgrund der Kenntnis der magnetischen und mechanischen Kenngrößen entsprechend den Wechselrichter steuern können bzw, die Strangantriebsspannungen derart vorgeben können, dass die Maschine optimal ohne Überschwingen die gewünschten Arbeitsaufgaben erfüllen kann. In diesem Zusammenhang werden die Begriffe Steuerung und Regelung synonym verwendet. Die Kenntnis der magnetischen und mechanischen Kenngrößen der Antriebsstrecke kann folglich der Parametrierung des Stromreglers dienen, dessen Anforderung an eine hohe Dynamik als innerster Regler am höchsten ist. Insbesondere anspruchsvolle Regelungsverfahren, die über die von konventionellen PI-Reglern hinausgehen, verlangen eine präzise Kenntnis der Maschinenkenngrößen, insbesondere Massenträgheit und Magnetfluss. Hierbei sind insbesondere Zustandsraumregler, Dead-Beat-Regler oder Modellfolgeregler zu nennen. Da in jüngster Zeit insbesondere sensorlose Motorsteuerungen eingesetzt werden, können mittels des vorgeschlagenen drehgeberlosen Verfahrens die magnetischen und mechanischen Kenngrößen von bereits im mechanischen Antriebsstrang integrierten oder ausgetauschten Drehstrommotoren in einer komplexen Maschinenumgebung ermittelt werden, und der Motorregler vor Ort eingestellt werden. Die magnetischen und mechanischen Kenngrößen wirken sich auf das elektrische Verhalten aus, so dass insbesondere bei der Regelung komplexer transienter Übergangsvorgänge der Maschine eine genaue Ansteuerung des Wechselrichters ermöglicht wird. Hierbei wird eine überschwingfreie Reglereinstellung und eine optimiert schnelle Dynamikregelung des Motors ermöglicht. Denkbar ist insbesondere die Anwendung einer solchen optimierten Motorregelung unter genauer Kenntnis der mechanischen und magnetischen Kenngrößen im Bereich von Druckmaschinen, Kunststoffoberflächen-Herstell- und Bearbeitungsmaschinen oder von Walz- und Verpackungsmaschinen, bei denen dynamikoptimierte Motorsteuerungsverfahren eingesetzt werden müssen. Insbesondere bei Vierfarbdruckmaschinen können kleinste Abweichungen im Farbdruck bei Motorsteuerungsungenauigkeiten erkennbar werden. Bei der Herstellung extrem glatter und dünner Kunststoffoberflächen kann eine gleichmäßige Dicke der Kunststoffschicht nur bei optimaler Dynamikregelung erreicht werden, wobei keine optischen Verunreinigungen des Kunststoffmaterials auftreten können. Während der Analyse der magnetischen und mechanischen Kenngrößen bewegt sich der Rotor nur in geringem Umfang, und kann somit im eingebauten Zustand unter nur geringem Einfluss auf den Abtriebsstrangs lediglich durch elektrische Strom/Spannungsmessungen identifiziert werden. Eine Reglerparametrierung dient der Optimierung der Steuerparameter des Wechselrichters, wobei eine Abweichung der Kenngrößen von beispielsweise vorhergegangenen Messungen zur Fehlerüberwachung des Motors oder zur Verschleißkontrolle berücksichtigt werden kann. Insbesondere kann der Einsatz des Verfahrens im Rahmen eines "Condition Monitoring" des Motors vorteilhaft sein, so dass von Zeit zu Zeit das Verfahren die Kenngrößen neu ermitteln, adaptiv den Motorregler anpassen und bei auffälligen Abweichungen gegenüber zuvor identifizierten oder voreinstellbaren Kenngrößenwerten eine Fehlersignalisierung ausgeben kann, so dass Motor oder Ansteuerelektronik überprüft werden können.

In einem nebengeordneten Aspekt der Erfindung wird eine Identifikationseinrichtung nach Anspruch 10 vorgeschlagen.

Somit betrifft diese Erfindung eine Identifikationseinrichtung, die dazu ausgelegt ist, ein vorgenanntes Verfahren auszuführen und hierzu die Möglichkeit eröffnet, mittels einer Wechselrichter-Interfaceeinheit mit einer Wechselrichter-Steuereinrichtung, insbesondere mit den Halbleiterschaltbauteilen des Wechselrichters zu kommunizieren, um diese zu schalten bzw. deren Betriebszustand abzufragen. Durch gerichtete Ansteuerung des Wechselrichters kann eine Ausrichtung der $d$-Rotor-Hautmagnetflussachse gegenüber der $\alpha$-Statorachse vorgenommen werden, sowie eine Testsignaleinspeisung in die $q$-Rotorquerfeldachse vorgenommen werden. Dabei können beispielsweise Drehzahl- oder Drehgebersensoren Aufschluss über einen Ausrichtung des Rotors und gegebenenfalls über einen Rotorwinkel $\beta_k$ der $d$-Achse gegenüber der $\alpha$-Achse geben. Diese Sensoren werden allerdings nicht zur Parameteridentifikation an sich benötigt, eine heuristische Kenntnis über einen angenommenen Rotorstillstand kann in den meisten Fällen genügen. Die Identifikationseinrichtung umfasst eine Testsignalerzeugungseinrichtung, die ein $q$-Testsignal erzeugen kann, wobei das Testsignal, insbesondere ein PRB-Rauschsignal, mittels einer $U/V/W$-Transformationseinheit in Abhängigkeit des Rotorwinkels $\beta_k$ in ein entsprechendes $U/V/W$-Steuertestsignal umgewandelt werden kann, das der Wechselrichter-Steuereinrichtung zuführbar ist. Das Steuertestsignal erzeugt in dem Motor ein entsprechendes Testsignal in den drei Motorstrangen. Des Weiteren umfasst die identifikationseinrichtung eine $d/q$ die gemessenen $I_u$, $I_v$ und $I_w$-Meßsignalströme in $d/q$-Meßsignalströme $I_d$ und $I_q$ umwandeln kann und eine Parameteridentifikationseinheit, die ausgehend von der im Zeitbereich vorliegenden Testsignalspannung $U_q$ und gemessenen Meßsignalstrom $I_q$ eine Parameteridentifikation nach vorgenannten Verfahren durchführen kann. Eine derartige Identifikationseinrichtung kann mehrteilig aufgebaut sein, wobei zur Erzeugung des Testsignals der Motorkontroller einer Motorsteuervorrichtung verwendet werden kann. Der gemessenen Strom kann von der Motorsteuerungsvorrichtung aufgezeichnet werden. Ein externer Rechner kann die gemessenen und eingespeisten Spannungen und Ströme auslesen, in den Frequenzbereich transformieren und eine Parameteridentifikation durchführen.

Gemäß einer vorteilhaften Weiterbildung der Identifikationseinrichtung kann die Parameteridentifikationseinheit ein Fouriertransformationsmittel, insbesondere ein FFT/DFT-Mittel zur diskontinuierlicher $d/q$-Abtast-Signalwerte nach dem Welch-Verfahren und ein Parameterbestimmungsmittel, insbesondere ein Levenberg-Marquardt-Übertragungsfunktions-Parameterbestimmungsmittel umfassen. Demgemäß umfasst die Parameteridentifikationseinheit ein Fouriertransformationsmittel zur Überführung der eingespeisten und gemessenen Spannungs- und Strom-Zeitabtastwerte $U_{1q}$, $I_{1q}$ und ein Parameterbestimmungsmittel, das ausgehend von der im Frequenzbereich vorliegenden Übertragungsfunktion G eine Bestimmung der Übertragungsfunktionskoeffizienten $a_0$, $a_2$, $b_0$, $b_1$ und $b2$ und dadurch der zugrundeliegenden Systemparameter vornehmen kann. Die hierzu erforderlichen Rechenverfahren können beispielsweise innerhalb eines DSPs, eines Mikrocontrollers eines FPGAs, eines PCs oder eines Kleinrechners durchgeführt werden, wobei eine logische und bauliche Trennung zwischen Testsignalerzeugung, Abtastwert-Signalspeicherung, Fouriertransformation und Parameterbestimmung möglich ist. Die Signalverarbeitung und das abschließende numerische Verfahren kann vorteilhaft als Softwareimplementierung zumindest teilweise auf einem Motorregler bzw. Motorsteuerungsvorrichtung vorgesehen sein.

So ist denkbar, das Fouriertransformationsmittel als FPGA aufzubauen, um eine schnelle Fouriertransformation mit Hilfe eines statischen Schaltkreises zu realisieren, und das Parameteridentifikationsmittel als variable Rechensoftware auf einem Hochleistungs-DSP eines Motorsteuerreglers zu implementieren. Eine Testsignalerzeugung und Abtastwert-Signalspeicherung kann innerhalb einer Wechselrichter-Motorsteuerungsvorrichtung durchgeführt werden. Fouriertransformation und Parameteridentifikation kann ebenfalls durch eine Motorsteuerungsvorrichtung oder durch eine externe Identifikationseinrichtung, die ein Interface zur Kommunikation mit der Motorsteuerungsvorrichtung aufweist, erfolgen. Somit kann die Motorsteuerungsvorrichtung mit geringer Rechenleistung ausgerüstet sein, und anspruchsvolle signaltheoretische Aufgaben in einer externen Identifikationseinrichtung, die an die Motorsteuerungsvorrichtung anschließbar ist, abgearbeitet werden, wodurch Hardwareaufwand eingespart werden kann.

Gemäß einer vorteilhaften Weiterbildung kann die Einrichtung des Weiteren eine Überwachungs- und Optimierungseinheit umfassen, die eingerichtet ist, auf Basis der identifizierten magnetomechanischen Kenngrößen Steuerparameter einer Wechselrichter-Steuereinrichtung zu bestimmen, zu optimieren und/oder zu überwachen. Die Überwachungs- und Optimierungseinheit empfängt die identifizierten Kenngrößen der Parameteridentifikationseinheit und kann auf Basis der bestimmten magnetischen und mechanischen Kenngrößen Steuerungsparameter der Motorsteuervorrichtung optimieren, insbesondere hinsichtlich eines dynamischen Reglerverhaltens und/oder Filtereigenschaften, um die Auswirkungen des induktiven Verhaltens des Synchronmotors auf das Netz zu verringern. Des Weiteren kann ein effizienter Betrieb der Motorsteuerung optimiert und Motorveränderungen überwacht bzw. beim Motorausfall oder Fehlverhalten ein Fehlersignal ausgegeben werden. Die hierzu benötigten magnetischen und mechanischen Kenngrößen können im Rahmen eines "Condition-Monitorings" durch die Überwachungs- und Optimierungseinheit routinemäßig nach einem bestimmten Zeitintervall oder beispielsweise bei Auswechseln des Motors oder Motorteilen erneut vorgenommen werden.

In einem nebengeordneten Aspekt schlägt die Erfindung eine Motorsteuerungsvorrichtung zur drehgeberlosen Steuerung bzw. Regelung eines Drehstrom-Synchronmotors vor, die eine zuvor beschriebene Identifikationseinrichtung zur drehgeberlosen Identifikation magnetischen und mechanischen Kenngrößen umfasst, wobei die identifizierten Kenngrößen zur Bestimmung, Optimierung und Überwachung des Motors und/oder der Motorsteuerung verwendbar sind. Somit schlägt dieser Aspekt eine Motorsteuerungs- bzw. Motorregelungsvorrichtung vor, die in üblicher Weise eine sensorbasierte oder drehgeberlose Steuerung bzw. Regelung des Drehzahlverhaltens des Synchronmotors vornehmen kann und die eine Identifikationseinrichtung umfasst oder in Verbindung mit einer solchen Identifikationseinrichtung steht, und die die magnetischen und mechanischen Kenngrößen zur Optimierung des Regelverhaltens, zur Bestimmung elektrischer Größen für die Ansteuerung des Motors und für die Überwachung eines fehlerfreien Verhaltens des Synchronmotors und/oder der Motorsteuerng verwendet. So können die ermittelten Kenngrößen zur optimalen Einstellung von Steuerungskennlinien dienen, so dass ein dynamisches Regelverhalten überschwingfrei ermöglicht werden kann. Somit können die identifizierten Kenngrößen zur Optimierung des Stromverbrauchs und der Energieeffizienz des Synchronmotors herangezogen werden und beispielsweise für eine Filterparametrierung zur Einstellung elektronischer Filter eingesetzt werden oder sie können zur Überwachung des fehlerfreien Verhaltens der Motorsteuerungsvorrichtung und/oder des Synchronmotors herangezogen werden. Im Falle eines vorbestimmbaren Abweichens der identifizierten Kenngrößen gegenüber zuvor bestimmten oder vorgegebenen magnetischen und mechanischen Kenngrößen kann ein Fehlerfall angenommen werden, beziehungsweise eine Neubestimmung der Kenngrößen durchgeführt werden. Im Falle einer Reparatur oder einer Auswechslung des Motors kann die Motorsteuerungsvorrichtung adaptiv die Kenngrößen des neuen Motors identifizieren und sich optimiert auf den neuen Motor einstellen. Eine Selbstkalibrierung der Motorsteuerungsvorrichtung kann werksseitig erfolgen, oder beim Einbau der Maschine beim Kunden, beziehungsweise im laufenden Betrieb im Rahmen eines "Condition Monitorings".

In einer vorteilhaften Weiterbildung wird vorgeschlagen, dass die Motorsteuerungsvorrichtung derart eingerichtet ist, dass zumindest bei der erstmaligen Inbetriebnahme, bevorzugt mehrmals im Laufe des Betriebslebens, eine automatisierte Identifikation der Kenngrößen vornehmbar ist, wobei bei einer vorstellbaren Abweichung der identifizierten Kenngrößen von vorherig bestimmten gespeicherten und/oder modellbezogenen Kenngrößen eine Fehlersignalisierung auslösbar ist. Somit schlägt dieser Aspekt vor, dass zumindest bei einer erstmaligen Inbetriebnahme, beziehungsweise einem Testlauf werksseitig, bevorzugt jedoch im Rahmen eines "Condition Monitorings", oder bei Reparatur oder Austausch von Teilen des Motors eine Kenngrößenidentifikation vorgenommen wird, wobei die Motorsteuerungsvorrichtung zur Optimierung, Einstellung und Überwachung des Motors die identifizierten magnetischen und mechanischen Kenngrößen berücksichtigen kann. Somit kann eine "universelle" Motorsteuerungsvorrichtung geschaffen werden, die sich adaptiv an eine ganze Reihe unterschiedlicher Synchronmotoren anpassen kann, wobei im Motorstillstand eine Identifikation der elektrischen Größen vornehmbar ist. Alterungsbedingte Veränderungen des Motors können durch eine adaptive Korrektur der Reglerparameter berücksichtigt werden und Fehlfunktionen des Motors oder der Motorsteuerungsüberwachung können erkannt werden.

Schließlich wird in einem nebengeordneten Aspekt der Erfindung eine Verwendung des vorgenannten Verfahrens zur Bestimmung, Optimierung und Überwachung von Motorregelparametern für die Steuerung bzw. Regelung elektrischer Antriebe, insbesondere zur Einstellung von Regelungsparametern einer Motorsteuerungsvorrichtung vorgeschlagen. In diesem Aspekt wird vorgeschlagen, dass die ermittelten Kenngrößen zur Regleroptimierung, Parametrierung und Überwachung eingesetzt werden. Eine Ermittlung der magnetischen und mechanischen Kenngrößen kann beispielsweise für eine Baureihe von Synchronmotoren einmalig an einem Mustermotor vorgenommen werden, und entsprechende Regelparameter für die hierfür eingesetzten Motorsteuerungsvorrichtungen optimiert und angepasst werden. Dies kann werksseitig erfolgen. Ist in einer Motorsteuerungsvorrichtung eine Identifikationseinrichtung vorgesehen oder extern anschließbar, so kann diese im eingebauten Zustand des Motors bei Erstinbetriebnahme, bei Reparaturmaßnahmen oder routinemässiger oder laufender Zustandsüberwachung ("Condition Monitoring") eine Neuidentifikation der Kenngrößen vornehmen. Hierzu können Teile des Verfahrens, wie die Frequenzbereichstransformation und die Parameterbestimmung, auf einem externen Rechner ausgeführt werden, und andere Teile, wie beispielsweise die Einspeisung des Testsignals und die Konvertierung vom Dreiphasensystem in das Zweikoordinatensystem, innerhalb der Motorsteuerungsvorrichtung vorgenommen werden. Entscheidend ist jedoch, dass die identifizierten Kenngrößen zur optimalen Reglerparametrierung, Filtereinstellung, elektrischer Bauteildimensionierung verwendbar sind.

Zeichnungen

Weitere Vorteile ergeben sich aus der folgenden Zeichnungsbeschreibung. In der Zeichnung sind Ausführungsbeispiele der vorliegenden Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen beispielhaft:

Fig. 1 ein Ersatzschaltbild einer Statorspule eines Synchronmotors in Sternschaltung;

Fig. 2 Darstellung des Zusammenhangs zwischen Zweikomponenten- und Dreiphasenkoordinatensystems;

Fig. 3 schematisch ein Aufbau eines Synchronmotors mit Kurzschlussläufer;

Fig. 4 schematisch eine Feder-Masse-Prinzipskizze eines erfindungsgemäßen Meßverfahrens sowie ein Ersatzschaltbild eines Synchronmotors;

Fig. 5 ein erstes Ausführungsbeispiel einer Motorsteuerungsvorrichtung der Erfindung;

Fig.6 ein Ausführungsbeispiel einer Motorsteuerungsvorrichtung gemäß der Erfindung;

Fig.7 einen Ablaufplan eines Ausführungsbeispiels des erfindungsgemäßen Verfahrens;

Fig.8 schematisch ein Ausführungsbeispiel einer Testsignaleinspeisung in ein mathematisches Modell eines Synchronmotors;

Fig.9 schematisch ein Darstellung des Zusammenhangs zwischen Meßsignalstrom $I_{1q}$ und Rotorlagewinkel $\beta_k$;

Fig.10 ein Betrag-Phasenverlauf-Vergleich einer Admittanz aus simulierten Zeitbereichsdaten und einem Maschinenmodell bei Anwendung eines erfindungsgemäßen Verfahrens auf verschiedene Synchronmaschinentypen;

Fig.11 ein Betrag-Phasenverlauf einer Admittanz aus gemessenen Zeitbereichsdaten bei Anwendung eines erfindungsgemäßen Verfahrens;

AUSFÜHRUNGSFORMEN DER ERFINDUNG

In den Figuren sind gleiche oder gleichartige Komponenten mit gleichen Bezugsziffern bezeichnet.

Zur Erläuterung der Erfindung zeigt Fig. 1 ein Ersatzschaltbild der Statorspule 01 eines Drehstrommotors. Jeder Spulenstrang *U, V* und *W* umfasst einen Widerstand $R_s$ 03 und eine Induktivität $L_s$ 05. Die drei Spulenstränge 07 sind an ihrem ersten Ende miteinander verbunden und an ihrem zweiten Ende an die drei Phasen *U, V, W* des Ausgangs eines Wechselrichters angeschlossen. Die Statorspule 01 interagiert mit der drehbar gelagerten Rotorspule 11, die eine konstante Magnetisierung in einer d-Flussachsenrichtung aufweist. Das Rotormagnetfeld kann durch entlang des Rotorumfangs angebrachte Permanentmagnete oder durch einen über Schleifringe eingespeisten Gleichstrom in einer Rotorwicklung erzeugt werden. Das Rotormagnetfeld heftet sich an das sich drehende Statormagnetfeld und lässt somit den Rotor in der Frequenz des Statormagnetfeldes drehen. Das System aus Rotorspule 11 und Statorspule 01 kann statt in einem Drehphasensystem *U/V/W* in einem Stator-Zweikoordinatensystem α/β oder Rotor-Zweikoordinatensystem *d/q* betrachtet werden, woraus das in Fig. 4 dargestellte Ersatzschaltbild des Motors 09 abgeleitet werden kann.

Hierzu zeigt zunächst Fig. 2 die räumliche Zuordnung des Dreiphasensystems *U/V/W* mit den drei Koordinatenrichtungen 1 (0°), $e^{j2\pi/3}$ (120°) und $e^{j4\pi/3}$ (240°) gegenüber dem Koordinatensystem α/β der komplexen Ebene mit Realteil α und Imaginärteil β. Unter Annahme eines Gesamtstroms I kann dieser in Bezug auf das Dreiphasensystem in drei Teilströme $I_U$, $I_V$ und $I_W$ aufgeteilt werden. In gleicher Weise kann der Strom durch die Teilströme in komplexen statorfesten Koordinatensystem $I_\alpha$, und $I_\beta$ ausgedrückt werden. Die Relation zwischen $I_\alpha$, $I_\beta$ und $I_U$, $I_V$ und $I_W$ sind bereits weiter oben angegeben worden. Unter Verwendung der komplexen Darstellung $I_\alpha$ und $I_\beta$, die die ortsfesten Statorachsenrichtungen angeben und den drei Strangströmen $I_U$, $I_V$ und $I_W$ können die obige Transformationsvorschrift hergeleitet werden. Der Rotor besitzt ein drehendes Koordinatensystem *d/q*, das die Rotor-Flussachse *d* und Querflussachse *q* aufweist. Der Zusammenhang zwischen den sich drehenden Koordinaten *d/q* und den ortsfesten Koordinaten α/β kann durch den Rotordrehwinkel $\beta_k$ hergestellt werden.

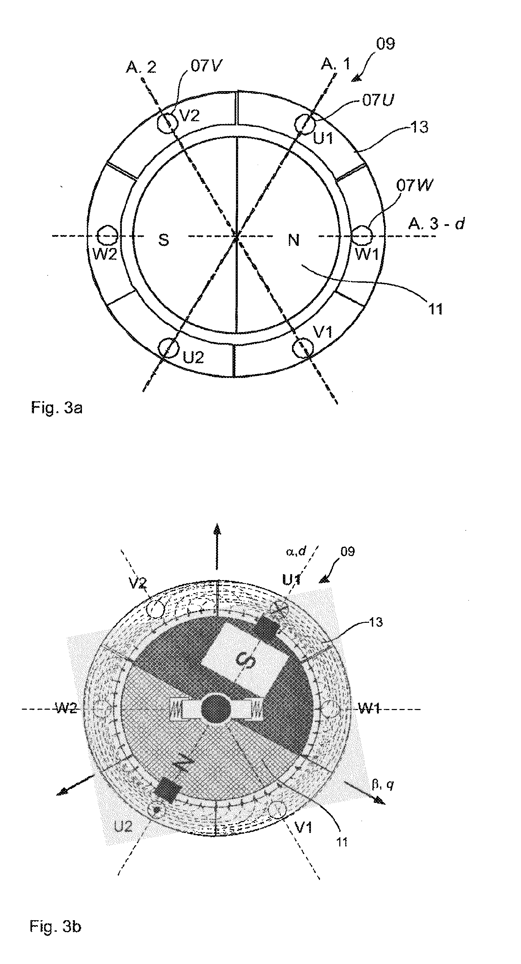

In Fig. 3a ist schematisch der Aufbau eines Permanentmagnet-Drehstrom-Synchronmotors 09 (PMSM) dargestellt. Dieser umfasst in einer einfachen Ausführung einen dreiphasigen Stator 13 mit den Spulensträngen U1, U2 (07-U), V1, V2 (07-V) und W1, W2 (07-W). Die ortsfesten Statorspulen definieren drei Spulenachsen A1, A2 und A3, die den in Fig. 2 gezeigten drei Phasenachsen 1, $e^{j2\pi/3}$ und $e^{j4\pi/3}$ entsprechen. Der Rotor 11 umfasst einen permanentbestückten Läufer, wobei sich das Permanentmagnetfeld des Rotors 11 an das sich elektrisch drehende Statormagnetfeld heftet und somit ein Drehmoment bewirkt, so dass der Rotor 11 in Drehung versetzt wird. In Fig. 3b ist schematich ein Magnetdurchflutung $\Psi_{PM}$ von Rotor 11 und Stator 13 bei bestromter Strornspule 07-U dargestellt, wobei Statorhautachse α und Rotor-Hauptmagnetflussrichtung *d* zusammenfallen.

In Figs. 4a und 4b sind schematisch die Wirkung einer Einspeisung eines Testsignals auf einen Permanentmagnetrotor 11 dargestellt. Zunächst wird in Fig. 4a die *d*-Achse mit der α -Achse ausgerichtet, hierzu wird eine Konstantspannung $U_{1\alpha}$ beispielsweise mit 10 V DC in α-Richtung in den Stator eingespeist, so dass sich eine Konstantbestromung $I_{1\alpha}$ ergibt. Dadurch wird der Motor in die Flussachse (*d*-Achse) orientiert, wobei sich die Welle des Rotors bewegt. Die α-Achse entspricht jetzt der *d*-Achse und die β-Achse entspricht jetzt der *q*-Achse. Die Konstanteinspeisung muss während der gesamten Identifikationsprozedur aufrecht erhalten werden, d.h. auch während das Testsignal eingespeist wird, wie nachfolgend erörtert wird. Somit kann nachfolgend eine federähnliche Wirkung erzeugt werden. In Fig. 4b erfolgt nun parallel zur Konstantspannungseinspeisung die Einspeisung eines Testslgnals $U_{1\beta}$ als PRB-Signal in die β-Achsenrichtung. Mit der Einspeisung des PRBS in die β-Achse (=*q*-Achse für diesen Fall wird die stabile Lage des Rotors gestört und es kommt zu einer Auslenkung und damit zu einem Drehmoment. Der konstante Strom $I_{1\alpha}$. wirkt dagegen und wird den Rotor wieder in die Flussachse ziehen wollen.

Daher ist es wichtig, dass die Amplituden der Konstantspannung und des PRBS in einem angemessenen Verhältnis stehen. Wäre die Konstantspannung in der α-Achse deutlich zu groß, wäre die Wirkung wie eine mechanisch festgebremste Maschine. Das hier beschriebene Verfahren fußt darauf, dass die Maschine sich aus der Flussachse heraus bewegen und darin zurückkehren kann.

Das somit gebildete Feder-Masse-System ist schematisch in Fig. 4c dargestellt. Die Konstantbestromung $I_{1\alpha}$ bewirkt den Aufbau einer Rotor-Stator Magnetflussverkettung, die eine federähnliche Rückstellung einer Austenkungsbewegung 75 des Massesystems 75 bewirkt. Die Auslenkungsbewegung wird durch eine Bestromung $I_{1\beta}$ in die β-Achse, die der *q*-Achse entspricht, bewirkt.

Die Fig. 4d stellt ein Ersatzschaltbild eines Synchronmotors mit dem Strangstrom $I_1$ und der Strangspannung $U_1$ dar. Die Spannungsquelle $U_P$ beschreibt die Gegeninduktionswirkung des Rotormagnetfelds in der Statorspule 01. Das Ersatzschaltbild nach Fig. 4d beschreibt die elektrischen Vorgänge in der Statorspule 01 mit $R_1$, $L_1$ 03, 05. Auf Basis des Ersatzschaltbilds, unter Einbeziehung der Vereinfachung einer Ausrichtung der *d*- zur α-Achse und Anwendung des Induktionsgesetzes kann folgende Admittanzfunktion hergeleitet werden:

$$G_\beta(s) = \frac{I_{1\beta}(s)}{U_{1\beta}(s)} = \frac{s^2\ J + K_T\ p\ I_{1\alpha}}{s^3\ J\ L_1 + s^2\ J\ R_1 + s\left(L_1\ K_T\ p\ I_{1\alpha} + \Psi_{PM}\ K_T\ p\right) + R_1\ K_T\ p\ I_{1\alpha}}$$

Aufgabe der vorliegenden Erfindung ist es nun, die Kenngrößen J und $\Psi_{PM}$ aus dem Schaltbild der Fig. 4d abzuleiten. Ausgehend von der Kenntnis der Ersatzschaltbildgrößen $L_1$, $R_1$, die aus bekannten oder vergleichbaren Identifikationsparamter zuvor bestimmt werden können, kann bei eingespeisten Spannungen $U_\beta$ der sich einstellenden Strom $I_\beta$ gemessen und im Frequenzbereich die Übertragungsfunktion $G_\beta$ bestimmt werden. Mittels eines geeigneten Parameteridentifikationsverfahrens können die unbekannten Übertragungsparameter bestimmt und die magnetomechanischen Kenngrößen identifiziert werden. Wesentlich dabei ist eine Beschreibung des transienten Verhaltens, wobei eine einzige Analyse des elektrischen Verhaltens des Motors eine möglichst genaue Kenntnis über die magnetomechanischen Parameter liefert.

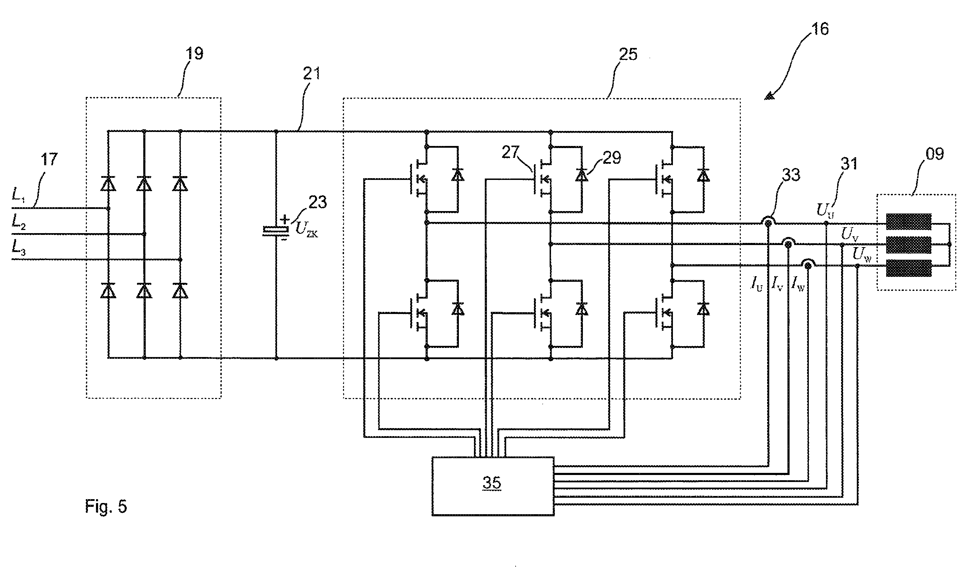

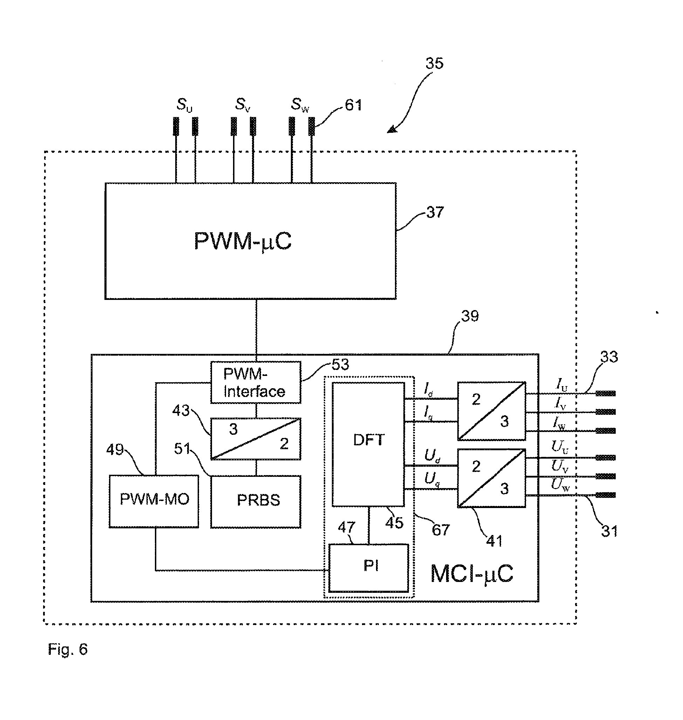

Fig. 5 zeigt schematisch eine Motoransteuerschaltung 16, bei der die Phasen eines Drehstromversorgungsnetzes 17 mittels eines Dreiphasen-Brückengleichrichters 19 in eine Gleichspannung eines DC-Zwischenkreises 21 umgewandelt werden. Im DC-Zwischenkreis 21 ist ein Pufferkondensator 23 vorgesehen, der die Spannung glättet und beispielsweise bei Stromausfall Pufferenergie für einen geregelten Notfahrbetrieb des Motors 09 zur Verfügung stellen kann. Ein Wechselrichter 25 umfasst drei Schaltbrücken, in denen Leistungshalbleiter-Schaltelemente 27 die Motorstränge *U/V/W* gegenüber der Gleichspannung +DC und -DC des Zwischenkreises 21 koordiniert schalten können, und somit drehzahlvariabel eine PWM-modellierte Ansteuerspannung $U_u$, $U_v$, $U_w$ für den Drehstrommotor 09 bereitstellen. Jedes Leistungshalbleiterschaltelement 27, das ein IGBT-Transistor, ein Bipolar-Leistungstransistor oder Ähnliches umfassen kann, ist mittels einer Freilaufdiode 29 gegen Überspannung, insbesondere induktive Rückwirkung durch den Motor 09, geschützt. Die Strangspannungen $U_u$, $U_v$, $U_w$ 31 sowie Strangströme $I_u$, $I_v$, $I_w$ 33 werden in den Zuführleitungen zu dem Drehstrommotor 09 abgegriffen, und einer Motorsteuerungsvorrichtung 35 zugeführt. Die Strangspannungen müssen nicht notwendigerweise abgegriffen werden, da diese vom Wechselrichter 25 vorgegeben werden können, wobei angenommen wird, dass der Spannungssollwert dem Spannungsistwert entspricht. Die Motorsteuerungsvorrichtung 35 umfasst Steuerleitungen, um die einzelnen Leistungshalbleiterschaltelemente 27 je nach gewünschtem Drehzahlverhalten des Motors 09 phasenrichtig anzusteuern. Im Falle einer sensorbasierten Regelung ist die Motorsteuerungsvorrichtung 35 des Weiteren mit Positionswinkel- und Beschleunigungssensoren gekoppelt, wobei auch Temperatursensoren zur Überwachung der Betriebstemperatur des Motors 09 angeschlossen werden können. Im Falle einer drehgeberlosen feldorientierten Regelung kann die Motorsteuerungsvorrichtung 35 lediglich durch Kenntnis der Strangspannungen 31 und gemessenen Strangströmen 33 eine drehzahloptimierte Ansteuerung der Wechselrichter-Schaltbauteile 27 vornehmen. Die Regelparameter der Motorsteuerungsvorrichtung 35 können durch Kenntnis des elektrischen Verhaltens des Motors 09, der sich durch das in Fig. 4 dargestellte Ersatzschaltbild beschreiben lässt, eingestellt werden. Hierzu umfasst die Motorsteuerungsvorrichtung 35 eine Identifikationseinrichtung 39, wie sie in Fig. 6 dargestellt ist.

In der Fig. 6 ist ein Ausführungsbeispiel einer Motorsteuerungsvorrichtung 35 dargestellt, die eine Identifikationseinrichtung 39 zur Extraktion der Kenngrößen des Drehstrom-Synchronmotors 09 umfasst. Die Motorsteuerungsvorrichtung 35 weist Eingänge zur Erfassung der drei Strangströme $I_U$, $I_V$ und $I_W$ 33 sowie der drei Strangspannungen $U_U$, $U_V$ und $U_W$ 31 des Drehstrommotors 09 auf, wobei eine Erfassung von nur zwei Strangspannungen und Strangströmen genügt, da sich die dritte Größe nach Kirchhoff ergibt. Des Weiteren umfasst die Motorsteuerungsvorrichtung 35 Schaltausgänge 61 zur Ausgabe von Wechselrichter-Schaltsignalen zur Betätigung der Leistungshalbleiter-Schaltelemente 27 des Wechselrichters 25. Die phasenrichtige Erzeugung der Wechselrichter-Schaltsignale 61 erfolgt mittels eines PWM (Pulse-Width Modulation)-Mikrocontrollers, der eine Wechselrichter-Steuereinrichtung 37 darstellt, um sensorlos oder auch sensorgestützt eine Drehzahl- und Drehmomentregelung des Drehstrommotors 09 vorzunehmen. Die Identifikationseinrichtung 39 empfängt die Strangspannungen 31 und Strangströme 33 und umfasst eine $d/q$-Transformationseinheit 41, die Strangspannungen und Strangströme in die Teilspannung $U_d$, $U_q$ sowie Teilströme $I_d$, $I_q$ des komplexen Zweikoordinatensystems umwandelt. Die umgewandelten Strangspannungen und Strangströme werden in eine Parameteridentifikationseinheit 67 eingespeist, die zum einen ein Fouriertransformationsmittel 45 und zum anderen ein Parameterextraktionsmittel 47 umfasst. Auf die Zeitbereichsdaten der Strangspannungen und Strangströme wird eine Fouriertransformation angewendet, so dass diese Daten im Frequenzbereich vorliegen und oben definierte Admittanz-Übertragungsfunktion $G_1$ gebildet werden kann. Anstelle der Admittanzfunktion können Parameter einer anderen Übertragungsfunktion, insbesondere Impedanzfunktion oder andere sinnvolle elektrische Funktionsbeziehungen zugrunde gelegt und deren Parameter bestimmt werden. Ausgehend von den Verläufen der Übertragungsfunktionen kann die Parameteridentifikationseinheit 67 des Parameterextraktionsmittels 47 unter Kenntnis der zugrunde liegenden Admittanz-Beschreibungsfunktion die zu identifizierende Koeffizienten $a_0$, $a_2$, $b_0$, $b_1$ und $b_2$ aus den Kurvenverläufen extrahieren. Hieraus können die Systemparameter, insbesondere die magnetischen und mechanischen Kenngrößen ermittelt werden, und auf deren Basis kann eine Optimierungseinheit 49, die eine Modulierung des Motors sowie eine Optimierung von Parametereinstellungen der Pulsweitenerzeugung vornehmen kann, Steuerparameter sowie Filterparameter für die Parametrierung, Optimierung und Überwachung der Wechselrichter-Steuereinrichtung 37 erzeugen. Diese werden an ein PWM-Interface 53 weitergeleitet und können somit an die Wechselrichter-Steuereinrichtung 37 übermittelt werden, um eine optimale Regelung des Synchronmotors zu ermöglichen.

Im Rahmen der Kenngrößenidentifikation werden Testsignale eingespeist, die über eine Testsignalerzeugungseinheit 51 generiert werden können. In diesem Ausführungsbeispiel wird als Testsignal ein Pseudo-Rausch-Binär-Signal (PRBS) erzeugt, das mittels einer *U/V/W*-Transformationseinheit 43 das Rauschsignal gleichmäßig als $U_\alpha/U_\beta$ bereitstellt und auf die drei Strangspannungen $U_U$, $U_V$ und $U_W$ verteilt wird. Dieses Eingangssignal wird an die Wechselrichter-Steuereinrichtung 37 weitergeleitet, die entsprechend den Wechselrichter 25 so steuert, dass der Motor 09 entsprechend dem Testsignal bestromt wird.

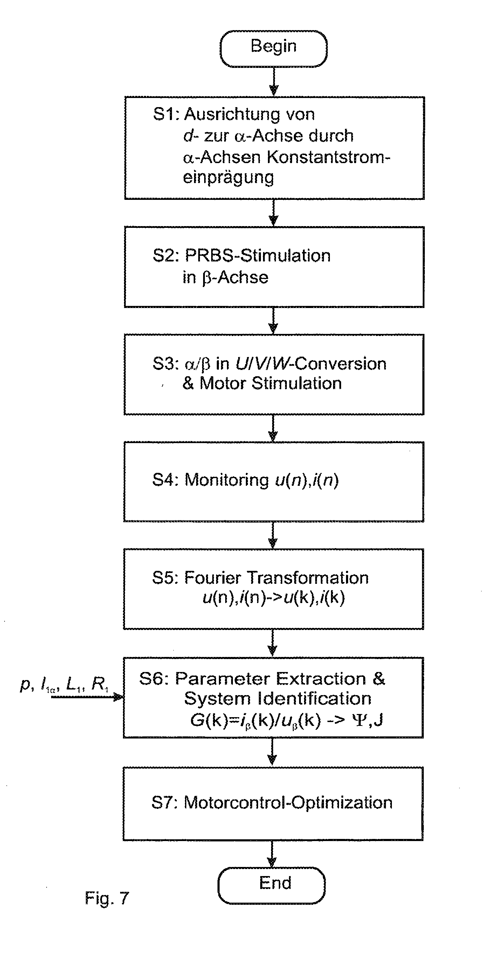

In der Fig. 7 ist ein Ausführungsbeispiel eines Programmablaufplans zur Durchführung eines erfindungsgemäßen Verfahrens dargestellt. In Schritt S1 wird zunächst der Rotor in einer definierte Fixposition und Stillstandslage gebracht, bei der die Umdrehungszahl n gleich 0 beträgt. Dabei erfolgt eine Konstantbestromung durch Einspeisung einer DC-Konstantspannung in die $\alpha$-Achsrichtung des Stators, so dass sich die *d*-Rotorachse entlang der $\alpha$-Statorachse ausrichtet. Die DC-Bestromung wird während des gesamten Messvorgangs beibehalten. In Schritt S2 wird die Einspeisung eines Testsignals als PRB-Signal in die $\beta$-Achse, die der *q*-Achse des Rotors entspricht, vorgenommen. Aus dem $\alpha$-DC und $\beta$-Testsignal wird eine Konversion in die Strangspannungen $U_U$, $U_V$ und $U_W$ durchgeführt und damit der Motor angesteuert. Die angesteuerten Spannungssignale *U*(n) sowie die gemessenen Stromwerte *I*(n) werden im Zeitbereich abgetastet und mittels einer Fouriertransformation, insbesondere einer DFT (Diskreten Fourier Transformation) oder FFT (Fast Fourier Transformation) unter Verwendung einer Welch-Methode, in den Frequenzbereich, d.h. in diesem Fall in den Laplace-Bereich überführt, so dass sich die Frequenzbereichswerte *U*(k), *I*(k) ergeben. Im Laplace-Bereich kann eine Übertragungsfunktion der Admittanz dargestellt werden als

$$G(k) = I(k)/U(k),$$

die die Ausgangsbasis für die Kenngrößenidentifikation bildet. Unter Kenntnis der Übertragungsfunktion und Wissen über Polpaarzahl *p*, Konstantstromgröße $I_{1a}$ und Größe der Ersatzschaltbildparameter $L_1$, $R_1$ kann mittels einer Systemidentifikation eine Parameterextraktion, beispielsweise aufbauend auf den Levenberg-Marquardt-Algorithmus durchgeführt werden, um die Übertragungsfunktionskoeffizienten $a_0$, $a_2$, $b_0$, $b_1$ und $b_2$ aus dem Kurvenverlauf zu ermitteln. Hieraus können die Systemparameter, insbesondere die Werte der magnetischen und mechanischen Kenngrößen *J* und $\Psi_{PM}$ abgeleitet werden, und zur Einstellung von Motorsteuerungsparametern, zur Optimierung von Lastwechseln oder Drehmomentwechseln und zur Einstellung und Auslegung von Filterparametern für ein Filtern von Motorströmen oder Motorspannungen herangezogen werden. Durch die Kenntnis der magnetomechanischen Kenngrößen kann eine Parametrierung der Wechselrichter-Steuereinrichtung 37 vorgenommen werden, wobei eine hohe Dynamik des Motorverhaltens durch Optimierung des Regelverhaltens der Wechselrichter-Steuereinrichtung als innerster regler erreicht werden kann, Dabei können anspruchsvolle Regelungsverfahren, die weit über die Möglichkeiten eines konventionellen PI-Reglers des Synchronmotors hinausgehen, erreicht werden, da eine präzise Kenntnis der elektrischen Maschinenparameter vorliegt. Insbesondere können die Reglerparameter für einen, Zustandsraumregler, einen Dead-Beat-Regler oder einer Modellfolgeregelung exakt eingestellt werden.

In der Fig. 8 ist schematisch die Einspeisung eines Testsignals einer Testsignals-Erzeugungseinheit 51 in ein mathematisches Modell eines Drehstrom-Synchronmotors 59 als *d/q*-Modell im Rahmen einer Matlab-Simulink Simulation dargestellt, wobei angenommen wird, dass die *d*-Achse mit der $\alpha$-Achse übereinstimmt Die Testsignal-Erzeugungseinheit 51 umfasst ein $\alpha$/*d*~Testsignal-Erzeugungsmiltel 65, das ein Pseudo-Rausch-Binärsignal erzeugt, welches im Takt einer Wechselrichter-Steuereinrichtung 37, die im Regelfall mit 16 kHz Taktrate, d.h. 62.5 $\mu$s Taktdauer arbeitet, bereitgestellt wird. Da das *d/q*~Motormodell 59 mit quasi analogen Signalen modelliert werden kann, ist eine Abtasterhöhungseinheit 55 zwischengeschaltet, die aus dem grob abgetasteten 16 kHz Testsignal ein quasi kontinuierliches Testsignal erzeugt. Dieses wird durch einen Testsignalverstärker 57 verstärkt als Motorspannung $U_{\beta/q}$ in das *d/q*-Synchronmotormodell 59 eingespeist. Parallel hierzu erzeugt ein ebenfalls von der Testsignal-Erzeugungseinheit 51 umfasstes $\alpha$-Testsignal-Erzeugungsmittel 63 ein DC-Gleichspannungssignal, dass als Hauptmagnetflussachsenspannung $U_d$ in das Synchronmotormodell 59 eingespeist wird. Eine Simulation erfolgt dabei mit Matlab-Simulink, um eine mathematische Verifikation des Verfahrens durchzuführen, Ausgehend von der numerischen Simulation werden die Verläufe der Strangströme durch eine Signalaufzeichnungseinheit 69 aufgezeichnet, woraus sich ein resultierendes Drehmoment für eine "schaukelnde" Rotorbewegung in einem engen Winkelbereich ergibt.

Die Fig. 9 zeigt schematisch die Berechnungsvorschrift zur Bestimmung des Rotorlagenwinkels $\beta_k$ auf Basis des Meßstroms $I_{1q}$ Die Eingangsgröße des Blockschaltbildes ist die drehmomentbildende Komponente des Statorstroms $I_{1q}$. Diese wird mit der Drehmomentkonstante $K_T$ multipliziert und ergibt das Drehmoment $M=J\alpha$: Durch Integration und Division durch das Massenträgheitsmoment *J* ergibt die Drehfrequenz $\Omega_K$, wird diese nochmals integriert und mit der Polpaarzahl *p* multipliziert, erhält man den Rotorlagewinkel $\beta_k$. Im Laplacebereich kann eine Integration durch eine Division durch s ersetzt werden.

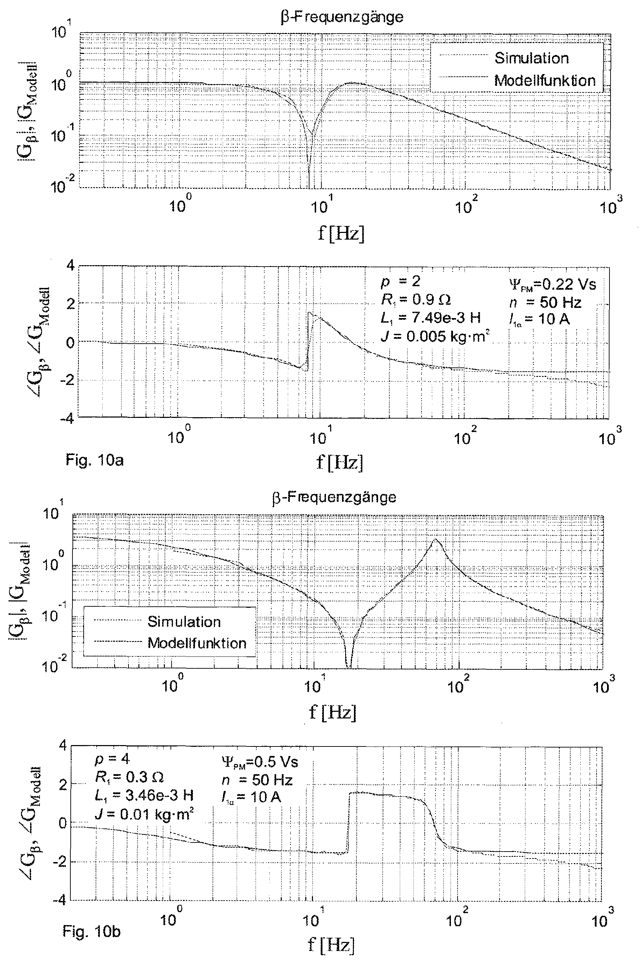

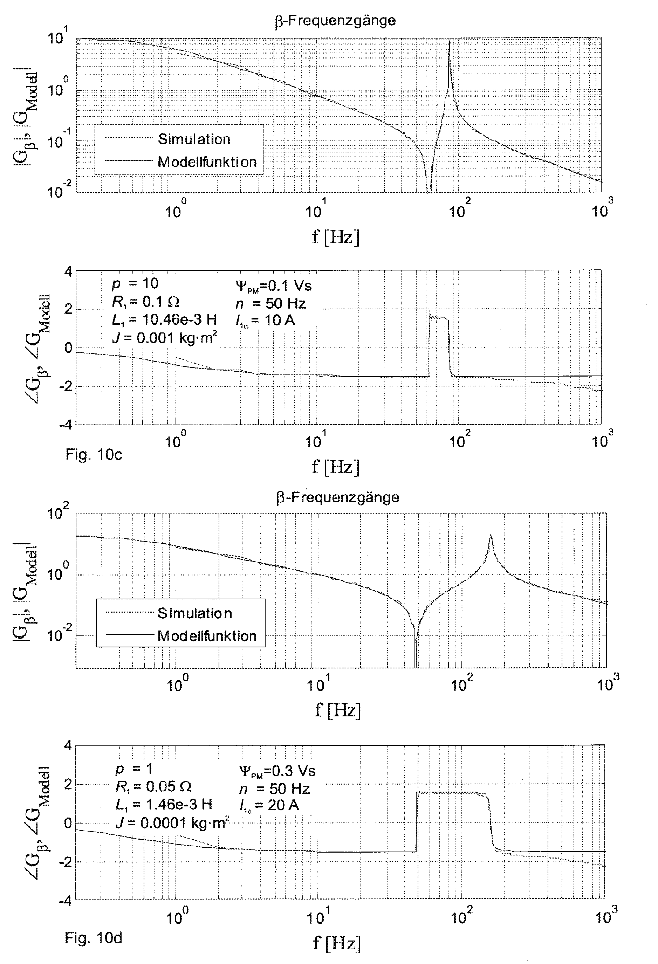

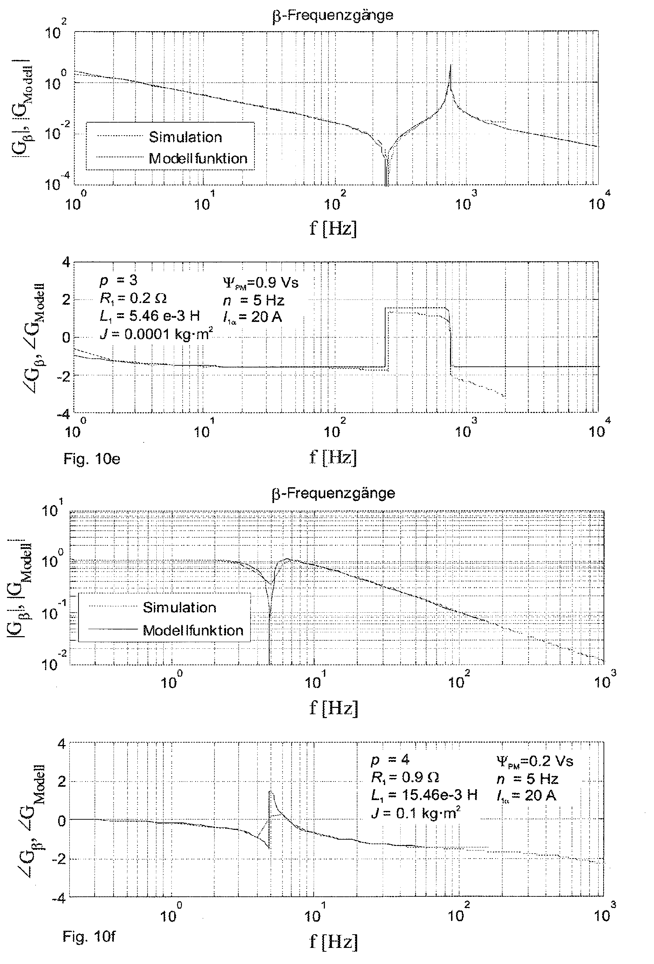

In Figs. 10a bis 10f sind Betrags- und Phasenverläufe verschiedener Synchronmotortypen über einen Frequenzbereich von 0-1 kHz der Admittanz-Funktion $G=\underline{Y}$, die aus dem identifizierten elektrischen System und aus den exakten Maschinenmodell abgeleitet wurde, dargestellt. Deutlich ist zu erkennen, dass die Übertragungsfunktionen G nahezu identisch mit dem jeweiligen exakten Maschinenmodellen übereinstimmen. Somit kann mittels numerischer Simulation eine Verifikation des theoretischen Modells nachgewiesen werden. Ausgehend von dem im Zeitbereich gemessenen abgetasteten Strangspannungen und Strangströmen kann eine nahezu identische Systemcharakterisierung des elektrischen Verhaltens des Drehstrommotors 09 abgeleitet werden.

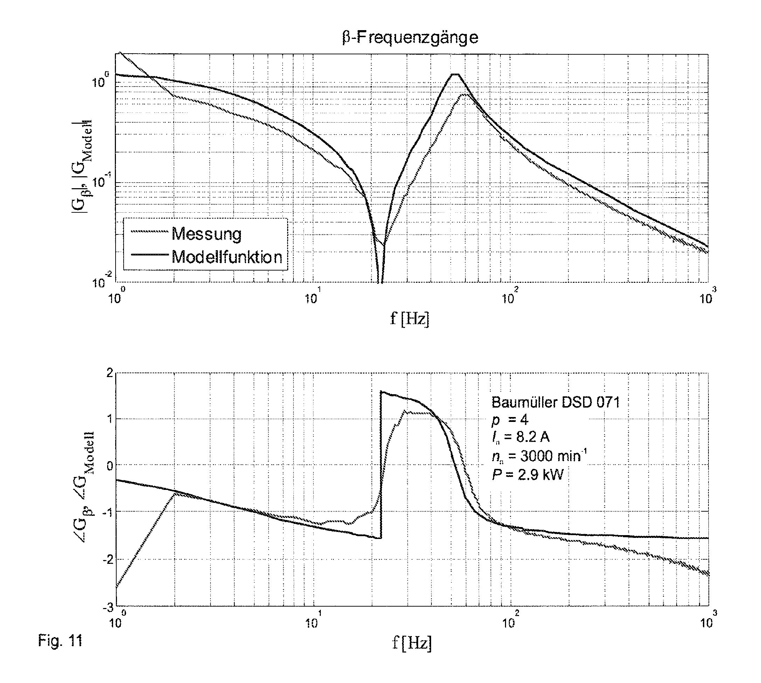

In Fig. 11 ist ein Oszillogrammverlauf der gemessenen Positionssignale während der Selbstidentifikation bei Verwendung eines erfindungsgemäßen Verfahrens dargestellt. Der betrachtete Motor ist ein Baumüller DSD071 Motor mit einer Nennleistung von $P_N$=2,9 kW, Nenndrehzahl $n_N$=3000-', einer Polpaarzahl $p$=4 und einem Nennstrom $I_N$=8.2 A. Die Parameter für die Modellfunktion wurden im vorliegenden Fall anhand des Datenblattes der Maschine geschätzt. Man erkennt eine sehr gute Übereinstimmung zwischen gemessenem Frequenzgang und Modellfunktion.

Die grundsätzliche Idee der Erfindung beruht auf einer signaltheoretischen Betrachtung eines Drehstrom-Elektromotors in einem Zweikoordinatenraum $d/q$, wobei mittels unsymmetrischer Einspeisung eines breitbandigen Testsignals, bevorzugt eines PRB-Signals als Motorspannungen in Richtung der $q$-Hauptmagnetflussachse des Rotors, Auswertesignale, die als Motorströme vorliegen, in den Frequenzbereich mittels bevorzugt eines Welch-Verfahrens transformiert werden können. Aufbauend darauf können Übertragungsfunktionen aus den eingespeisten und gemessenen Signalen extrahiert werden und mittels einer Parameteridentifikationsmethode, bevorzugt einem Levenberg-Marquardt-Algorithmus, die zugrunde liegenden magnetischen und mechanischen Systembeschreibungsparameter ausgewertet werden. Durch Kenntnis des formelmäßigen Zusammenhangs der Übertragungsfunktionen können die einzelnen Koeffizienten identifiziert und damit das mechanische und magnetische Verhalten des Motors über einen großen Frequenzbereich charakterisiert werden. Besonderen Schwerpunkt legt die Erfindung auf die besondere Einspeisungsart, die Struktur der Übertrelgungsfunktion und die bei eine Bestimmung der magnetomechanischen Kenngrößen ermöglicht wird. Das Verfahren bildet das transiente Verhalten des Motors über einen großen Arbeitsfrequenzbereich bzw. Drehzahlbereich ab und kann zur Einstellung, Optimierung und Überwachung des Motors verwendet werden, insbesondere bei Einsatz in einer Motorsteuerungsvorrichtung kann eine universelle Motorsteuerungsvorrichtung bereitgestellt werden, die adaptiv werksseitig oder nach Einbau des Motors bei Verkopplung mit einem mechanischen Abtriebsstrang zur Bestimmung des Motorverhaltens benutzt werden kann. Eine motorschonende und schnelle Bestimmung der maschinenbeschreibenden Kenngrößen ohne besonderem Hardwareaufwand wird dadurch ermöglicht Das Verfahren kann softwaretechnisch in bestehenden Motorsteuerungsvorrichtungen wie beispielsweise den Baumüller b_maXX-Motorsteuerungen und Servoregler, insbesondere b_maXX 1000-5000 nachgerüstet werden und eröffnet eine automatisierte Identifikation und Überwachung der motorbeschreibenden Parameter.

**Bezugszeichenliste**

01    Statorspulen-Ersatzschaltbild eines Synchronmotors
03    Spulenwiderstand
05    Spuleninduktivität
07    *U*/*V*/*W*-Spulenstrang
09    Synchronmotor
11    Rotor
13    Stator
15    Ersatzschaltbild einer Ständerspule eines Synchronmotors
16    Motoransteuerschaltung
17    AC-Versorgungsnetz
19    Dreiphasen-Brückgleichrichter
21    DC-Zwischenkreis
23    Pufferkondensator
25    Wechselrichter
27    Leistungshalbleiter-Schaltelement
29    Freilaufdiode
31    Strangspannung
33    Strangstrom
35    Motorsteuerungsvorrichtung
37    Wechselrichter-Steuereinrichtung
39    Identifikationseinrichtung
41    $\alpha/\beta$-Transformationseinheit
43    *U*/*V*/*W*-Transformationseinheit
45    Fouriertransformationsmittel

47    Parameterbestimmungsmittel
49    Optimierungseinheit
51    Testsignal-Erzeugungseinheit
53    Wechselrichtersteuerungs-Interfaceeinheit
55    Abtastratenerhöhungseinheit
57    Testsignalverstärker
59    $\alpha/\beta$-Synchronmotor-Modell
61    Wechselrichter-Schaltsignale
63    $\alpha$-Testsignal-Erzeugungsmittel
65    $\beta$-Testsignal-Erzeugungsmittel
67    Parameteridentifikationseinheit
69    Signalaufzeichnungseinheit
71    Multiplikator
73    Integrator
75    Auslenkungsbewegung
77    Feder-Masse-System
79    Magnetomechanische Größen Trägheitsmoment $J$ & Permanentmagnetfluss $\Psi_{PM}$

## Patentansprüche

1. Verfahren zur drehgeberlosen Identifikation zumindest einer mechanischen Kenngröße (79), insbesondere des Massenträgheitsmoments ($J$), und zumindest einer magnetischen Kenngröße (79), insbesondere des Permanentmagnetflusses ($\Psi_{PM}$) zwischen Rotor (11) und Stator (13), eines Drehstrom-Synchronmotors (09), **dadurch gekennzeichnet, dass** es
zumindest umfasst die Schritte:

- Konstantspannungseinspeisung ($U_{1d}$) in $d$-Flussachsenrichtung als Hauptmagnetflussrichtung des Rotors (11) durch Einprägung eines Gleichstroms $I_{1d}=I_{DC}$. die eine Ausrichtung des Rotors gegenüber dem Stator bewirkt, wobei kein Drehmoment auf den Rotor ausgeübt wird;
- Frequenzgangsmessung durch Testsignalspannungseinspeisung ($U_{1q}$) in zur $d$-Flussachsenrichtung rechtwinkliger $q$-Querachsenrichtung des Rotors (13), wobei die $d$-Flussachsenrichtung DC-bestromt bleibt;
- Meßsignalstrommessung ($I_{1q}$) der $q$-Querflussachsenrichtung;
- Identifikation der magnetischen und mechanischen Kenngrößen (79) des Synchronmotors (09) auf Basis der digital erfassten zeitlichen Abtastwerte der Testsignalspannung ($U_{1q}$) und des Meßsignalstroms ($I_{1q}$) durch Analyse des Frequenzgangs der gemessenen Übertragungsfunktion unter Kenntnis der Übertragungsfunktion im Frequenzbereich eines Ersatzschaltbildes eines Synchronmotors mittels Parameterextraktion;

wobei die Testsignaleinspeisung in den Synchronmotor (09) derart erfolgt, dass der Rotor (11) aufgrund der Testsignaleinspeisung Auslenkungsbewegungen (75) mit vordefinierbaren Maximalamplituden ausführen kann.

2. Verfahren nach Anspruch 1,
**dadurch gekennzeichnet,**
**dass** unter Kenntnis der Lage der $d/q$-Rotorachsenrichtungen gegenüber den $\alpha/\beta$-Statorachsenrichtungen eine entsprechende Spannungseinspeisung ($U_{1\alpha}$, $U_{1\beta}$) erfolgt, so dass in $d$-Flussachsenrichtung ein konstantes Statormagnetfeld und in $q$-Querflussachsenrichtung eine Testsignaleinspeisung durchführbar ist.

3. Verfahren nach Anspruch 2,
**dadurch gekennzeichnet,**
**dass** eine Konstantspannungseinspeisung ($U_{1\alpha}$) in $\alpha$-Achsenrichtung des Stators (13) eine Ausrichtung der $d$-Flussachse des Rotors (11) bezüglich der $\alpha$-Achse des Stators (13) durch Einprägung eines Gleichstroms ($I_{1\alpha}=I_{DC}$) bewirkt; und

- eine Testsignalspannungseinspeisung ($U_{1\beta}$) in $\beta$-Achsenrichtung, erfolgt, wobei die $\alpha$-Achsenrichtung DC-bestromt bleibt; so dass
- ein Meßsignalstrommessung ($I_{1\beta}$) der $\beta$-Achsenrichtung messbar ist;

4. Verfahren nach einem der vorangegangenen Ansprüche,

**dadurch gekennzeichnet,**

**dass** das Verhältnis von Konstantspannung ($U_{1d}$) zur Testsignalspannung ($U_{1q}$) derart optimiert wählbar ist, um Maximalamplituden der Auslenkungsbewegung (75) in einer Höhe zu erreichen, so dass magnetomechanische Kenngrößen (79) eines einstellbaren Feder-Masse-Systems (77) mit einer vorbestimmbaren Genauigkeit ermittelt werden können.

5. Verfahren nach einem der vorangegangenen Ansprüche,
   **dadurch gekennzeichnet.**
   **dass** zur Identifikation der magnetomechanischen Kenngrößen (79) weitere Kenngrößen, insbesondere Ersatzschaltbildkenngrößen ($L_1$, $R_1$, 03, 05, 15) sowie mechanische Strukturgrößen wie Polpaarzahl ($p$) und/oder elektrische Meßgrößen ($I_{1\alpha}$, $I_{1\beta}$), insbesondere $I_{1\alpha}=I_{DC}$ des Synchronmotors (09) berücksichtigt oder ebenfalls identifiziert werden.

6. Verfahren nach einem der vorangegangenen Ansprüche,
   **dadurch gekennzeichnet,**
   **dass** das Testsignal ein Pseudo-Rausch-Binär-Signal ist.

7. Verfahren nach einem der vorangegangenen Ansprüche,
   **dadurch gekennzeichnet,**
   **dass** die Identifikation der magnetomechanischen Kenngrößen (79) eine Fouriertransformation von zeitdiskreten Signalen nach einem Welch-Verfahren umfasst.

8. Verfahren nach einem der vorangegangenen Ansprüche,
   **dadurch gekennzeichnet,**
   **dass** die Identifikation der magnetomechanischen Kenngrößen (79) eine Übertragungsfunktion-Parameterbestimmung insbesondere nach einem Levenberg-Marquardt-Algorithmus umfasst.

9. Verfahren nach einem der vorangegangenen Ansprüche,
   **dadurch gekennzeichnet,**
   **dass** die identifizierten magnetomechanischen Kenngrößen (79) bei einer Einstellung und/oder Optimierung von Wechselrichter-Steuerparametern und/oder zur Motorüberwachung verwendet werden.

10. Identifikationseinrichtung (39) zur drehgeberlosen Identifikation zumindest einer mechanischen Kenngröße (79), insbesondere des Massenträgheitsmoments ($J$) des Rotors (11), und zumindest einer magnetischen Kenngröße (79), insbesondere des Permanentmagnetflusses ($\Psi_{PM}$) zwischen Rotor (11) und Stator (13), eines Drehstrom-Synchronmotors (09),
    **gekennzeichnet dadurch,**
    **dass** die Identifikationseinrichtung (39)

    - eine Wechselrichter-Interfaceeinheit (53), die zur steuernden Kommunikation und zur Rotorpositionsbestimmung und zur Ausrichtung des Rotors gegenüber dem Stator, wobei kein Drehmoment auf den Rotor ausgeübt wird, mit einer Wechselrichter-Steuereinrichtung (37) verbindbar ist, wobei eine Konstantspannungseinspeisung ($U_{1d}$) in $d$-Flussachsenrichtung als Hauptmagnetflussrichtung des Rotors (11) durch Einprägung eines Gleichstroms $I_{1d}=I_{DC}$ erfolgt,
    - des Weiteren eine Testsignalerzeugungseinrichtung (51) zur Erzeugung eines $d/q$-Testsignals, wobei eine Testsignalspannungseinspeisung ($U_{1q}$) in zur $d$-Flussachsenrichtung rechtwinkliger $q$-Querachsenrichtung des Rotors (13) zur Frequenzgangsmessung dient, wobei die $d$-Flussachsenrichtung DC-bestromt bleibt, wobei die Testsignaleinspeisung in den Synchronmotor (09) derart erfolgt, dass der Rotor (11) aufgrund der Testsignaleinspeisung Auslenkungsbewegungen (75) mit vordefinierbaren Maximalamplituden ausführen kann,
    - eine $U/V/W$-Transformationseinheit (43) zur Transformation des $d/q$-Testsignals in ein $U/V/W$-Steuertestsignal,
    - eine $d/q$-Transformationseinheit (41) zur Transformation gemessener $U/V/W$-Meßsignalsströme in $d/q$-Meßsignalsströme zur Meßsignalstrommessung ($I_{1q}$) der $q$-Querflussachsenrichtung
    - und eine Parameteridentifikationseinheit (67) zur Identifikation der magnetischen und mechanischen Kenngrößen (79) auf Basis der digital erfassten zeitlichen Abtastwerte der Testsignalspannung ($U_{1q}$) und des Meßsignalstroms ($I_{1q}$) durch Analyse des Frequenzgangs der gemessenen Übertragungsfunktion unter Kenntnis der Übertragungsfunktion im Frequenzbereich eines Ersatzschaltbildes eines Synchronmotors mittels Parameterextraktion umfasst.

**11.** Einrichtung nach Anspruch 10,
**dadurch gekennzeichnet,**
**dass** die Parameteridentifikationseinheit (67) ein Fouriertransformationsmittel (45), insbesondere ein FFT/DFT-Mittel zur Fouriertransformation diskontinuierlicher *d/q*-Signalwerte nach dem Welch-Verfahren, und ein Parameterbestimmungsmittel (47), insbesondere ein Levenberg-Marquardt-Übertragungsfunktions-Parameterbestimmungsmittel, umfasst.

**12.** Einrichtung nach einem der Ansprüche 10 oder 11,
**dadurch gekennzeichnet,**
**dass** des Weiteren eine Überwachungs- und Optimierungseinheit (49) umfasst ist, die eingerichtet ist, auf Basis der identifizierten magnetomechanischen Kenngrößen (79) Steuerparameter einer Wechselrichter-Steuereinrichtung (37) zu bestimmen, zu optimieren und/oder zu überwachen.

**13.** Motorsteuerungsvorrichtung (35) zur drehgeberlosen Steuerung eines Drehstrom-Synchronmotors (09)
**gekennzeichnet dadurch,**
**dass** eine Identifikationseinrichtung (39) zur drehgeberlosen Identifikation magnetomechanischer Kenngrößen (79) eines Drehstrom-Synchronmotors (09) nach einem der vorgenannten Ansprüche 10 bis 12 umfasst ist, wobei die identifizierten Kenngrößen (79) zur Bestimmung, Optimierung und Überwachung des Motors (09) und/oder der Motorsteuerung verwendbar sind.

**14.** Vorrichtung nach Anspruch 13,
**dadurch gekennzeichnet,**
**dass** die Vorrichtung dergestalt eingerichtet ist, dass zumindest bei der erstmaligen Inbetriebnahme, bevorzugt mehrmals im Laufe des Betriebslebens eine automatisierte Identifikation der magnetomechanischen Kenngrößen (79) vornehmbar ist, wobei bei einer voreinstellbaren Abweichung der magnetomechanischen Kenngrößen (79) von zuvor bestimmten, gespeicherten und/oder modellbezogenen Kenngrößen (79) eine Fehlersignalisierung auslösbar ist.

**15.** Verwendung eines Verfahrens nach einem der vorangegangenen Verfahrensansprüche zur Bestimmung, Optimierung und Überwachung von Motorreglerparametern für die Steuerung elektrischer Antriebe, insbesondere zur Einstellung von Reglerparametern einer Motorsteuerungsvorrichtung (35).

**Claims**

**1.** A method is suggested for the identification of magnetomechanical characteristic quantities (79) without shaft encoder, in particular the mass moment of inertia (J) and the permanent magnetic flux ($\Psi_{PM}$) between the rotor (11) and the stator (13) of a three-phase synchronous motor (09),
comprising at least the steps:

- Constant voltage supply ($U_{1d}$) in d-direction of axial flux of the rotor (11) by impressing a direct current $I_{1d}=I_{DC}$;
- Test signal voltage supply ($U_{1d}$) in q-transverse axial direction of the rotor (13), wherein the d-direction of axial flux remains with DC current;
- Measurement of measuring signal current ($I_{1q}$) of the q-transverse axial direction;
- Identification of magnetomechanical characteristic quantities (79) of the synchronous motor (09) based on the test signal voltage ($U_{1q}$) and on the measuring signal current ($I_{1q}$);

wherein the supplying of a test signal into the synchronous motor (09) takes place in such a manner that the rotor (11) can execute deflection movements (75) with pre-definable maximal amplitudes based on the supplying of test signals.

**2.** The method according to Claim 1,
**characterized in that**
given knowledge of the position of the d/q rotor axis directions opposite the $\alpha/\beta$ stator axial directions, an appropriate ($U_{1\alpha}$, $U_{1\beta}$) supply takes place, so that a constant stator magnetic field can be carried out in the d direction of axial flux and a test signal supply can be carried out in the q direction of axial flux.

**3.** The method according to Claim 2,

**characterized in that**

supplying a constant voltage ($U_{1\alpha}$) in the $\alpha$ axial direction of the stator (13) brings about an alignment of the d flux axis of the rotor (11) relative to the $\alpha$ axis of the stator (13) by impressing a direct current $I_{1d}=I_{DC}$, and

- a supplying of test signal voltage ($U_{1\beta}$) takes place in the $\beta$ axial direction, wherein the $\alpha$ axial direction remains supplied with DC current so that
- a measuring signal current measuring ($I_{1\beta}$) of the $\beta$ axial direction can be measured.

4. The method according to one of the previous claims,
   **characterized in that**
   the ratio of constant voltage ($U_{1d}$) to test signal voltage ($U_{1q}$) can be selected in such an optimal manner for achieving maximal amplitudes of the deflection movement (75) at a height such that magnetomechanical characteristic quantities (79) of an adjustable spring-mass system (77) can be determined with a pre-determinable accuracy.

5. The method according to one of the previous claims,
   **characterized in that**
   further characteristic quantities, in particular equivalent circuit characteristic quantities $L_1$, $R_1$ (03, 05, 15) as well as mechanical structural magnitudes such as pole pair number p and/or electrical measuring magnitudes such as ($I_{1\alpha}$, $I_{1\beta}$), in particular $I_{1\alpha}=I_{DC}$ of the synchronous motor (09) can be taken into account or also identified.

6. The method according to one of the previous claims,
   **characterized in that**
   the test signal is a pseudo-noise binary signal.

7. The method according to one of the previous claims,
   **characterized in that**
   the identification of the magnetomechanical characteristic quantities (79) comprises a Fourier transformation of time-discrete signals according to a Welch method.

8. The method according to one of the previous claims,
   **characterized in that** the identification of the magnetomechanical characteristic quantities (79) comprises a transmission function - parameter determination, in particular according to a Levenberg-Marquardt algorithm.

9. The method according to one of the previous claims,
   **characterized in that**
   the identified magnetomechanical characteristic quantities (79) are used in an adjustment and/or optimization of inverter control parameters and/or for motor monitoring.

10. An identification apparatus (39) for the identification of at least one mechanical characteristic quantity (79) without shaft encoder, in particular the mass moment of inertia (J) of the rotor (11), and of at least one magnetic characteristic quantity (79), in particular of the permanent magnetic flux ($\Psi_{PM}$) between the rotor (11) and the stator (13) of a three-phase synchronous motor (09),
    **characterized in that**
    the identification apparatus (39) comprises

    - an inverter control interface unit (53), for the controlling communication and for determining the rotor position and for aligning the rotor relative to the stator, wherein no torque is applied on the rotor, which can be connected with an inverter control apparatus (37), wherein a constant voltage supply ($U_{1d}$) in d-flux axis direction for the main magnetic flux direction of the rotor (11) is effected by impressing a direct current $I_{1d}=I_{DC}$,
    - furthermore a test signal generation apparatus (51) for generating a d/q test signal, wherein a test signal voltage supply ($U_{1q}$), which is in the d-axis flux direction of the right angled q- cross-axis direction of the rotor (13), is used for the frequency response measurement, wherein the d- flux axis direction remains supplied with DC- current, wherein the test signal feed to the synchronous motor (09) takes place such that the rotor (11) can perform deflection movements (75) with pre-definable maximum amplitudes, on the basis of the test signal feed,
    - a U/V/W transformation unit (43) for the transformation of the d/q test signal into a U/V/W control test signal,
    - a d/q transformation unit (41) for the transformation of measured U/V/W measured signal currents into d/q measured signal currents for the measuring signal current measurement ($I_{1q}$) of the q- cross flux axis direction and
    - a parameter identification unit (67) for the identification of the magnetic and mechanical characteristic quantities (79) based on the digitally recorded time samples of the test signal voltage ($U_{1q}$) and of the measured signal currents ($I_{1q}$) by analysis of the frequency response of the measured transfer function with knowledge of the transfer function in the frequency range of an equivalent circuit diagram of a synchronous motor by means of parameter extraction.

11. The apparatus according to Claim 10,
**characterized in that**
the parameter identification unit (67) comprises a Fourier transformation means (45), in particular an FFT/DFT means for the Fourier transformation of discontinuous d/q scanning signal values according to the Welch method and comprises a parameter determination means (47), in particular a Levenberg-Marquardt transmission function-parameter determination means.

12. The apparatus according to one of Claims 10 or 11,
**characterized in that**
furthermore, a monitoring and optimization unit (49) is comprised that is set up to determine, optimize and/or monitor control parameters of an inverter control apparatus (37) on the basis of the identified magnetomechanical characteristic quantities (79).

13. A motor control device (35) for controlling a three-phase synchronous motor (09) without a shaft encoder,
**characterized in that**
an identification apparatus (39) for the shaft-encoderless identification of magnetomechanical characteristic quantities (79) of a three-phase synchronous motor (09) according to one of the previous Claims 10 to 12 is comprised, wherein the identified characteristic quantities (79) are used for the determination, optimization and monitoring of the motor (09) and/or of the motor control.

14. The device according to Claim 13,
**characterized in that**
the device is arranged in such a manner that an automated identification of the magnetomechanical characteristic quantities (79) can be carried out at least during the first startup, preferably several times in the course of the service life, wherein an error signal can be initiated upon a demonstrable deviation of the magnetomechanical characteristic quantities (79) from previously determined, stored and/or model-related characteristic quantities (79).

15. The use of a method according to one of the previous method claims for the determination, optimization and monitoring of motor regulator parameters for the control of electrical drives, in particular for the adjusting of regulating parameters of a motor control device (35).

**Revendications**

1. Procédé d'identification sans résolveur d'au moins une caractéristique mécanique (79), en particulier du moment d'inertie ($J$) et d'au moins une caractéristique magnétique (79), en particulier du flux magnétique permanent ($\Psi_{PM}$) régnant entre le rotor (11) et le stator (13) d'un moteur synchrone triphasé (09), **caractérisé en ce qu'**il comprend au moins les étapes suivantes :

- injection d'une tension constante ($U_{1d}$) dans la direction d'axe de flux d qui constitue la direction du flux magnétique principal du rotor (11), par application d'un courant continu $I_{1d} = I_{DC}$, qui provoque l'alignement du rotor par rapport au stator, aucun couple n'étant exercé sur le rotor,
- mesure de la réponse en fréquence par injection d'une tension signal de test ($U_{1q}$) dans la direction d'axe transversal $q$ du rotor (13) qui est perpendiculaire à la direction d'axe de flux $d$, la direction d'axe de flux $d$ restant parcourue par un courant continu,
- mesure du courant signal de mesure ($I_{1q}$) dans la direction d'axe de flux transversal $q$,
- identification des caractéristiques magnétiques et mécaniques (79) du moteur synchrone (09) sur la base des valeurs échantillons prises dans le temps, saisies en numérique, de la tension signal de test ($U_{1q}$) et du courant signal de mesure ($I_{1q}$), par analyse de la réponse en fréquence de la fonction de transfert mesurée, la fonction de transfert étant connue, dans le domaine de fréquence d'un schéma de branchement de remplacement d'un moteur synchrone, par extraction de paramètres,

l'injection du signal de test dans le moteur synchrone (09) s'effectuant de telle sorte que, sous l'effet de l'injection du signal de test, le rotor (11) peut décrire des mouvements d'excursion (75) ayant des amplitudes maximales pouvant être prédéfinies.

2. Procédé selon la revendication 1, **caractérisé en ce que** la position des directions d'axes du rotor $d/q$ par rapport aux directions d'axes du stator $\alpha/\beta$ étant connue, il s'effectue une injection de tension correspondante ($U_{1\alpha}$, $U_{1\beta}$) de telle sorte qu'il est possible de créer un champ magnétique de stator constant dans la direction d'axe de flux $d$ et d'exécuter une injection de signal de test dans la direction d'axe de flux transversal $q$.

3. Procédé selon la revendication 2, **caractérisé en ce qu'**une injection de tension constante ($U_{1\alpha}$) dans la direction d'axe $\alpha$ du stator (13) provoque un alignement de l'axe de flux $d$ du rotor (11) par rapport à l'axe $\alpha$ du stator (13) par application d'un courant continu ($I_{1\alpha} = I_{DC}$), et

    - une injection de tension signal de test ($U_{1\beta}$) est exécutée dans la direction d'axe $\beta$, la direction d'axe $\alpha$ restant parcourue par un courant continu, de sorte que
    - une mesure du courant signal de mesure ($I_{1\beta}$) de la direction d'axe $\beta$ peut être mesurée.

4. Procédé selon l'une des revendications précédentes, **caractérisé en ce que** le rapport de la tension constante ($U_{1d}$) à la tension signal de test ($U_{1q}$) peut être choisi de façon optimisée, pour atteindre des amplitudes maximales du mouvement d'excursion (75) à un niveau, pour pouvoir obtenir les caractéristiques magnétiques et mécaniques (79) d'un système ressort-masse réglable (77) avec une précision pouvant être prédéterminée.

5. Procédé selon l'une des revendications précédentes, **caractérisé en ce que**, pour l'identification des caractéristiques magnétiques et mécaniques (79), d'autres caractéristiques, en particulier des caractéristiques de schémas de branchement de remplacement ($L_1$, $R_1$, 03, 05, 15) ainsi que des grandeurs de structures mécaniques, comme le nombre de paires de pôles ($p$) et/ou des grandeurs de mesures électriques ($I_{1\alpha}$, $I_{1\beta}$), en particulier $I_{1\alpha} = I_{DC}$, du moteur synchrone (09), sont prises en compte ou également identifiées.

6. Procédé selon l'une des revendications précédentes, **caractérisé en ce que** le signal de test est un signal binaire de pseudo bruit.

7. Procédé selon l'une des revendications précédentes, **caractérisé en ce que** l'identification des caractéristiques magnétiques et mécaniques (79) comprend une transformation de Fourier de signaux temporels discrets selon un procédé de Welch.

8. Procédé selon l'une des revendications précédentes, **caractérisé en ce que** l'identification des caractéristiques magnétiques et mécaniques (79) comprend la détermination de paramètres d'une fonction de transfert, en particulier selon un algorithme de Levenberg-Marquardt.

9. Procédé selon l'une des revendications précédentes, **caractérisé en ce que** les caractéristiques magnétiques et mécaniques identifiées (79) sont utilisées lors de la détermination et/ou de l'optimisation des paramètres de commande d'un onduleur et/ou pour le contrôle d'un moteur.

10. Dispositif d'identification (39) pour l'identification sans résolveur d'au moins une caractéristique mécanique (79), en particulier du moment d'inertie ($J$) du rotor (11) et d'au moins une caractéristique magnétique (79), en particulier du flux magnétique permanent ($\Psi_{PM}$) régnant entre le rotor (11) et le stator (13) d'un moteur synchrone triphasé (09), **caractérisé en ce que** le dispositif d'identification (39) comprend

    - une unité interface d'onduleur (53), qui peut être connectée à un dispositif de commande d'onduleur (37) pour la communication des commandes et pour la détermination de la position du rotor ainsi que pour l'alignement du rotor par rapport au stator, aucun couple n'étant exercé sur le rotor, dans lequel une injection de tension constante ($U_{1d}$) dans la direction de l'axe de flux $d$, qui constitue la direction de flux magnétique principal du rotor (11), s'effectue par application d'un courant continu $I_{1d} = I_{DC}$),
    - en outre, un dispositif de production de signal de test (51) destiné à la production d'un signal de test $d/q$, dans lequel une injection de tension signal de test ($U_{1q}$) dans une direction d'axe transversal $q$ perpendiculaire à la direction d'axe de flux $d$ du rotor (13) sert à la mesure de la réponse en fréquence, la direction d'axe de flux $d$ restant parcourue par un courant continu, l'injection du signal de test dans le moteur synchrone (09) s'effectuant de telle sorte que le rotor (11) peut décrire sous l'effet de l'injection du signal de test, des mouvements d'excursion (75) ayant des amplitudes maximales pouvant être prédéfinies,

- une unité de transformation *U*/*V*/*W* (43), destinée à la transformation du signal de test *d*/*q* en un signal de test de commande *U*/*V*/*W*,

- une unité de transformation *d*/*q* (41) destinée à la transformation des courants signaux de mesure *U*/*V*/*W* mesurés en courants signaux de mesure *d*/*q* pour la mesure des courants signaux de mesure ($I_{1q}$) de la direction de l'axe de flux transversal *q*,

- et une unité d'identification des paramètres (67) destinée à effectuer l'identification des caractéristiques magnétiques et mécaniques (79) sur la base des valeurs d'échantillonnage prises dans le temps, saisies en numérique, de la tension signal de test ($U_{1q}$) et du courant signal de mesure ($I_{1q}$), par analyse de la réponse en fréquence de la fonction de transfert mesurée, la fonction de transfert dans le domaine de fréquence d'un schéma de branchement de remplacement d'un moteur synchrone étant connue, par extraction de paramètres.

11. Dispositif selon la revendication 10, **caractérisé en ce que** l'unité d'identification des paramètres (67) comporte un moyen de transformation de Fourier (45), en particulier un moyen FFT/DFT pour la transformation de Fourier de valeurs de signaux discontinues d/q selon le procédé Welch et un moyen de détermination de paramètres (47), en particulier un moyen de détermination des paramètres d'une fonction de transfert de Levenberg-Marquardt.

12. Dispositif selon l'une des revendications 10 ou 11, **caractérisé en ce que**, en outre, il comporte une unité de contrôle et d'optimisation (49) qui est conçue pour déterminer, optimiser et/ou contrôler, sur la base des caractéristiques magnétiques et mécaniques identifiées (79), des paramètres de commande d'un dispositif de commande d'onduleur (37).

13. Dispositif de commande de moteur (35) pour la commande sans résolveur d'un moteur synchrone triphasé (09), **caractérisé en ce qu'**il comprend un dispositif d'identification (39) destiné à l'identification sans résolveur de caractéristiques magnétiques et mécaniques (79) d'un moteur synchrone triphasé (09) selon l'une des revendications 10 à 12 précitées, les caractéristiques identifiées (79) pouvant être utilisées pour la détermination, l'optimisation et le contrôle du moteur (09) et/ou de la commande du moteur.

14. Dispositif selon la revendication 13, **caractérisé en ce que** le dispositif est conçu de telle sorte qu'au moins lors de la première mise en service, de préférence plusieurs fois au cours de la durée de vie utile, il est possible d'effectuer une identification automatisée des caractéristiques magnétiques et mécaniques (79), un signalement d'erreur pouvant être déclenché dans le cas d'un écart prédéterminable des caractéristiques magnétiques et mécaniques (79) par rapport à des caractéristiques (79) préalablement déterminées, mémorisées et/ou rapportées à un modèle.

15. Utilisation d'un procédé selon l'une des revendications de procédé précédentes, pour la détermination, l'optimisation et le contrôle de paramètres de régulateurs de moteurs pour la commande d'entraînements électriques, en particulier pour le réglage de paramètres du régulateur d'un dispositif de commande de moteur (35).

Fig. 1

Fig. 2

Fig. 3a

Fig. 3b

Fig. 3

Fig. 4a

Fig. 4b

Fig. 4c

Fig. 4d

Fig. 5

Fig. 6

Begin

S1: Ausrichtung von
$d$- zur $\alpha$-Achse durch
$\alpha$-Achsen Konstantstromeinprägung

S2: PRBS-Stimulation
in $\beta$-Achse

S3: $\alpha/\beta$ in $U/V/W$-Conversion
& Motor Stimulation

S4: Monitoring $u(n),i(n)$

S5: Fourier Transformation
$u(n),i(n)$->$u(k),i(k)$

$p, I_{1\alpha}, L_1, R_1$ → S6: Parameter Extraction &
System Identification
$G(k)=i_\beta(k)/u_\beta(k)$ -> $\Psi,J$

S7: Motorcontrol-Optimization

End

Fig. 7

EP 2 421 146 B1

Fig. 8

Fig. 9

30

β-Frequenzgänge

Fig. 10a

β-Frequenzgänge

Fig. 10b

β-Frequenzgänge

Fig. 10c

β-Frequenzgänge

Fig. 10d

β-Frequenzgänge

$p = 3$     $\Psi_{PM}=0.9$ Vs
$R_1 = 0.2\ \Omega$     $n = 5$ Hz
$L_1 = 5.46$ e-3 H     $I_{1\alpha} = 20$ A
$J = 0.0001$ kg·m$^2$

Fig. 10e

β-Frequenzgänge

$p = 4$     $\Psi_{PM}=0.2$ Vs
$R_1 = 0.9\ \Omega$     $n = 5$ Hz
$L_1 = 15.46$e-3 H     $I_{1\alpha} = 20$ A
$J = 0.1$ kg·m$^2$

Fig. 10f

Fig. 11

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1758239 A2

- JP 2010041839 A

**In der Beschreibung aufgeführte Nicht-Patentliteratur**

- Influence of the power density spectrum of the excitation signal, on the identification of drives. **VILLWOCK, S. et al.** INDUSTRIAL ELECTRONICS, 2008. IECON 2008. 34TH ANNUAL CONFERENCE OF IEEE. IEEE, 10. November 2008, 1252-1257
- **SEBASTIAN VILLWOCK.** *Identifikationsmethoden für die automatisierte Inbetriebnahme und Zustandsüberwachung elektrischer Antriebe,* 2007

- **S. VILLWOCK ; J. M. PACAS.** Application of the Welch-Method for the Identification of Two and Three Mass Systems. *IEEE Transactions on Industrial Electronics,* Januar 2008, vol. 55 (1), 457-466
- **P. SZCZUPAK ; J. M. PACAS.** Automatic Identification of a PMSM Drive Equipped with an Output LC-Filter. *IEEE Industrial Electronics, IECON 2006, 32nd Annual Conferenee,* November 2006, 1143-1148